# EUROPEAN PATENT APPLICATION

(11) **EP 1 107 405 A1**
(43) Date of publication of application: **13.06.2001**
(21) Application number: 99938681.6
(22) Date of filing: 05.08.1999
(51) Int. Cl.: H01S 5/32

(54) **INJECTION LASER**

(30) Priority: 10.08.1998 RU 98114581
(71) Applicant: Shveikin, Vasily Ivanovich, Moscow, 117393 (RU)
(72) Inventor: Shveikin, Vasily Ivanovich, Moscow, 117393 (RU)
(74) Representative: Liesegang, Eva
(86) International application number: PCT/RU99/00275
(87) International publication number: WO 00/10235

(57) **Abstract**

The present invention relates to an injection laser in which the optical resonator has a particular structure. The volume of the optical resonator medium includes an amplification area active volume for an intensive outlet amplification as well as a passive volume for the radiation inlet area (7). The volumes include a number of layers that form a laser heterostructure (2) and have compositions and thicknesses determined correspondingly. The optical faces (8,9) of the radiation inlet area (7) have different configurations, while said laser further uses ohmic contacts (15,16). It is thus possible to essentially determine the formation area of the laser radiation modes as well as the injection area of non-equilibrium carriers and of their stimulated recombination. It is also possible to increase the power of the laser radiation, to reduce the current threshold density, to increase the laser efficiency and to obtain reduced divergence angles which are close to the diffraction angle for two mutually perpendicular outlet directions of the radiation. It is further possible to increase the regularity of the single-mode generation process, to improve the spatial-spectral characteristics, to substantially reduce the wavelength dependency of the laser radiation generated on the amplitude of the pumping current, and to increase the service duration as well as the operation reliability. This invention relates to highly efficient lasers having a laser radiation outlet which is perpendicular to the plane of the active layer, as well as to lasers having powerful laser beams with the autonomous activation thereof.

## Description

### Area of Technology

The invention relates to quantum electronic technology, specifically to efficient, high-power, compact semiconductor injection sources of radiation with a narrow radiation pattern.

### Prior Art

The injection laser (hereinafter referred to as "the Laser") is a device that converts electrical energy into the energy of radiation possessing a narrow spectral composition and high directivity.

Different types of Lasers are known: Lasers with a strip-type active lasing region and with radiation output through the mirror of an optical resonator (S. S. Ou *et. al.*, *Electronics Letters* (1992), Vol. 28, No. 25, pp. 2345-2346), distributed-feedback Lasers *(Handbook of Semiconductor Lasers and Photonic Integrated Circuits*, edited by Y. Suematsu and A. R. Adams, Chapman-Hill, London, 1994, pp. 44-45 and 393-417), Laser amplifiers, including a master oscillator power amplifier (MOPA) *(IEEE J. of Quantum Electronics* (1993), Vol. 29, No. 6, pp. 2052-2057), and Lasers with curved resonators and radiation output through a surface *(Electronics Letters* (1992), Vol. 28, No. 21, pp. 3011-3012). Further expansion of the applications of such Lasers is impeded by insufficiently high radiation powers, efficiency, operating life, and reliability, including situations with monomode lasing.

The Laser described by D. R. Scifres *et al*. (U.S. Patent 4,063,189, 1977, H01S 3/19, 331/94.5 H) is closest. That Laser includes a laser heterostructure (hereinafter referred to as a "heterostructure") that contains an active layer of GaAs positioned between two optically homogeneous cladding layers. The gain region (hereinafter referred to as "the GR") of the operating Laser, of length *L*_{GR}, in practice coincides with the active layer into which nonequilibrium carriers are injected by means of ohmic contacts. The GR is the medium of the optical resonator. The length of the GR along the longitudinal gain axis is bounded by flat end surfaces that act as reflectors. The length *L*_{OR} of the optical resonator (abry-Perot) coincides with the length *L*_{GR}, so that the ratio$\text{µ =} {\text{L}}_{\text{OR}} \text{/} {\text{L}}_{\text{GR}}$ is equal to one. Reflective coatings with a coefficient of reflection of one (hereinafter referred to as "reflective coating") are applied to the reflectors of the optical resonator. The radiation inflow region (hereinafter referred to as "RIR"), as which a substrate of GaAs is used, borders on a surface of one of the cladding layers that is distant from the active layer. The inner surface of the RIR, whose area is equal to the area of the GR, is located on the cladding layer adjacent to the RIR. The flat optical facets of the RIR are a continuation of the planes of the reflectors of the optical resonator and are perpendicular to the longitudinal gain axis of the GR. A coating with a reflection coefficient close to zero (hereinafter referred to as "antireflective coating") is applied to one of the optical facets (hereinafter referred to as "the facet"), while a reflective coating is applied to the other facet. The facet with the applied antireflective coating is the output surface. The RIR is made electrically conductive, and an ohmic contact is made with its outer surface, which is opposite the inner surface. Another ohmic contact is made from the direction of the heterostructure. The composition and thicknesses of the active layer, cladding layers, and RIR are selected so that the condition for outflow of radiation from the active layer into the RIR is fulfilled, specifically so that the refractive index *n*_{RIR} of the RIR exceeds the effective refractive index *n*_{eff} of the heterostructure and of RIR 7, or (J. K. Buttler *et al*., *IEEE Journ*. *of Quant*. *Electron*. (1975), Vol. QE-11, p. 402):$\text{ϕ = arccos (} {\text{n}}_{\text{eff}} \text{/} {\text{n}}_{\text{RIR}} \text{) > 0.}$

When direct current is supplied to the Laser, nonequilibrium carriers are injected into the active layer, and generation of radiation of a specified wavelength λ and mode composition occurs in the medium of the optical resonator. At the same time, by virtue of the fulfillment of the aforementioned outflow condition, part of the laser radiation from the GR exits the Laser through the RIR. Note that the use of identical compositions for the active layer and RIR (both made of GaAs) restricted the range of ratios *n*_{eff}/*n*_{RIR} from more than 0.9986 to 1, and the outflow angle ϕ to the range from 3° to 0°, respectively.

The cited inventors (D. R Scifres *et al*., U.S. Patent 4,063,189, 1977, H01S 3/19, 331/94.5 H), as well as D. R. Scifres *et al.* (*Applied Physics Letters* (1976), Vol. 29, No. 1, pp. 23-25), obtained the following basic parameters for the fabricated Laser: a threshold current density *j*ₜₕᵣ of 7.7 kA/cm², a threshold current *J*ₜₕᵣ of 7.0 A for a length *L*_{OR} of 400 µm, a short-pulse output power of 3 W, a differential efficiency on the order of 35-40%, and an angle of divergence Θ₁ of 2° in the vertical plane for laser radiation output through the face. The plane that passes through the longitudinal gain axis and that is perpendicular to the active layer is the vertical plane (hereinafter). The horizontal plane is perpendicular to the vertical plane.

### Disclosure of the Invention

Underlying the invention was the object of making a Laser with a lower current-density threshold, increased differential efficiency, reduced astigmatism and angles of divergence of the output radiation in the vertical and horizontal planes, enhanced spectral characteristics of the laser radiation, an expanded range of direction of laser-radiation output, and increased effective length of the optical resonator, which in aggregate result in increased power, efficiency, operating life, and reliability of the Laser, including a multibeam Laser, with simplification of the technology for making it.

According to the invention, the stated object is attained by the fact that an injection laser is proposed which includes a laser heterostructure that contains an active layer and cladding layers, in which it is possible to form a gain region, and that also contains reflectors, an optical resonator, ohmic contacts, and on at least one side of the active layer a radiation inflow region whose inner surface borders on the corresponding cladding layer; here, the condition for radiation outflow from the active layer into the radiation inflow region is fulfilled if the refractive index *n*_{RIR} of the radiation inflow region exceeds the effective refractive index *n*_{eff} for the aggregate consisting of the laser heterostructure and the adjoining radiation inflow region, specifically, arccos (*n*_{eff}/*n*_{RIR}) is greater than zero, and at least part of the medium of the optical resonator is made of at least part of the inflow region and of at least part of the gain region, and at least one of the reflectors of the optical cavity is made with a reflection coefficient selected from the range greater than zero and less than one, there is at least one inflow region transparent to laser radiation and, from at least one part, the at least one gain region formed is characterized by a gain *G*_{outflow} (cm⁻¹) of outflowing radiation from the active layer into the inflow region, the latter being characterized by an introduced threshold loss factor α_{RIR-thr} (cm⁻¹), and the value of the gain *G*_{outflow} (cm⁻¹) is selected to be greater than the factor α _{RIR-thr} (cm⁻¹), and the condition for radiation outflow from the active layer into the radiation inflow region also is defined by the relations:$\text{arccos (} {\text{n}}_{\text{eff}} \text{/} {\text{n}}_{\text{RIR}} \text{) ≤ arccos (} {\text{n}}_{\text{eff-min}} \text{/} {\text{n}}_{\text{RIR}} \text{),}$ where *n*_{eff-min} is greater than *n*ₘᵢₙ, and where *n*_{eff-min} is the minimum value of *n*_{eff} out of all possible *n*_{eff} for the multiplicity of laser heterostructures with radiation inflow regions that are of practical value, and *n*ₘᵢₙ is the smallest of the refractive indices in the heterostructure cladding layers.

A distinction of the proposed Lasers is the unusual and nonobvious choice of the medium of the optical resonator, which consists of at least part of the RIR and of at least part of the GR. Negative optical feedback is assured by the fact that at least one of the reflectors of the optical resonator, which is disposed, for example, on one of the facets of the RIR, is made with a reflection coefficient selected from the range greater than zero and less than one. The choice of the compositions, thicknesses, and number of layers and sublayers of the heterostructure and RIR in the working Laser assures outflow of directional spontaneous radiation from the active layer (or GR) into the RIR with an intensity sufficient to fulfill the condition for lasing in the proposed optical resonator. Both for any Laser and for the proposed Laser, this condition is the condition that the radiation gain exceed the losses. This condition for attaining the lasing threshold of the Laser will be realized, in previously introduced terms, when the value of the gain *G*_{outflow} (cm⁻¹) of the outflowing radiation from the active layer into the RIR exceeds the value of the threshold loss factor α_{RIR-thr} (cm⁻¹), which characterizes all radiation losses in the optical resonator at the lasing threshold. The lasing-threshold condition obtained may be written as:${\text{G}}_{\text{outflow-thr}} {\text{= α}}_{\text{RIR-thr}} {\text{= (µ · α}}_{\text{RIR}} {\text{) + α}}_{\text{out}} {\text{+ α}}_{\text{diffr}} \text{,}$ where *G*_{outflow-thr} (cm⁻¹) is the value of the gain *G*_{outflow} at the lasing threshold, α_{RIR} is the optical loss factor (absorption, scattering) of the laser radiation in the RIR, αₒᵤₜ is the net loss factor, which is related to the laser radiation output from the optical resonator and which is equal to:${\text{α}}_{\text{out}} \text{= (2} {\text{L}}_{\text{GR}} {\text{)}}^{\text{-1}} \text{·1n (} {\text{R}}_{\text{1}} {\text{·R}}_{\text{2}} {\text{)}}^{\text{-1}} \text{,}$ α_{diffr} is the coefficient of diffraction losses of laser radiation at its exit from the optical resonator, which is equal to:${\text{α}}_{\text{diffr}} \text{=(} {\text{L}}_{\text{OR}} {\text{)}}^{\text{-1}} \text{·1n {1 - (λ·} {\text{L}}_{\text{OR}} \text{/} {\text{n}}_{\text{RIR}} \text{·} {\text{S}}_{\text{refl}} {\text{)}}}^{\text{-1}} \text{,}$ S_{refl} is the area of the reflectors of the optical cavity, *L*_{OR} is the length of the optical resonator; which is equal to (µ · *L*_{GR}) (see equation (1)), and *R*₁ and *R*₂ are the coefficients of reflection for the reflectors of the optical resonator.

Depending on the embodiment of the Laser, the ratio µ, equation (1), may range from approximately 0.8 to 3.0. The current density through the Laser at which relation (3) is fulfilled is the threshold current density *j*ₜₕᵣ.

Note that in the proposed Laser lasing should not occur in the GR, which, in both [the Laser of] D.F. Scifres *et al.* (U.S. Patent 4,063,189, 1977, H01S 3/19, 331/94.5 H) and other known Lasers, is the medium of the optical resonator. This is easily accomplished by selecting the mode of intensive outflow, in which the value of *G*_{outflow} (cm⁻¹) is selected to be close to the value of the total gain *G*_{GR} (cm⁻¹) of the radiation propagating in the GR, or more accurately, the following condition is fulfilled: the difference between the gains (*G*_{GR} - *G*_{outflow}) is smaller than the total loss factor α_{GR-thr} (cm⁻¹) of the radiation propagating in the GR. Moreover, the intensive outflow mode is preferable for the proposed Lasers, since it results in increased efficiency. In addition to the mode of intensive outflow of radiation from the GR, another distinction of the proposed Laser is that they implement the outflowing radiation mode for a wide range of outflow angles ϕ (relation (2)), and accordingly of the ratios (*n*_{eff}/*n*_{RIR}). It is proposed that the upper bound of the outflow angles in question ϕₘₐₓ be defined by the relations:$\text{arccos (} {\text{n}}_{\text{eff}} \text{/} {\text{n}}_{\text{RIR}} \text{) ≤ arccos (} {\text{n}}_{\text{eff-min}} \text{/} {\text{n}}_{\text{RIR}} {\text{) = ϕ}}_{\text{max}} \text{,}$$\text{for} {\text{n}}_{\text{eff-min}} \text{>} {\text{n}}_{\text{min}} \text{,}$ where *n*_{eff-min} is the minimum value of *n*_{eff} out of all possible *n*_{eff} for the multiplicity of heterostructures with inflow regions that are of practical value, and *n*ₘᵢₙ is the smallest of the refractive indices in the heterostructure cladding layers. Using numerical calculations for a heterostructure based on InGaAs/GaAs/AlGaAs compounds with a RIR of GaAs, which emit at wavelengths of 0.92-1.16 µm, we found that the maximum outflow angle ϕₘₐₓ is approximately 30°.

The proposed Laser with the aforementioned essential distinctions is not obvious. Its nonobviousness consists in the unusual use of spontaneous radiation directed at an angle to the longitudinal gain axis in the GR, followed by amplification thereof and lasing in the proposed nonstandard optical resonator. The path of the laser rays in such a resonator experiences a "bending" ("refraction"), with simultaneous amplification of the radiation; here, the angle ϕ of radiation outflow from the gain region in the RIR is made equal to the radiation inflow angle ξ for laser (and spontaneous) rays that are reflected from the reflectors of the optical resonator and that are directed from the RIR back into the GR. The aforementioned feature of optical-ray propagation was used for all proposed designs of the Laser, based on the known optical principle of the reversibility of the ray path in optical systems, which we applied to the multilayer laser heterostructure in aggregate with a RIR.

The aggregate of the essential characteristic features according to the claims determined the peculiarities of the functioning and the advantages of the proposed Lasers. Lasing and the process of generation of the corresponding modes in their optical resonator occur mostly as the laser rays propagate in the homogeneous, weakly absorbing volume of the RIR, and only after the laser rays reflected from the facets of the RIR are incident on the heterostructure (which generally is asymmetrical) to local amplification and total internal reflection of them occur. In known lasers the corresponding modes of laser radiation are formed in a fundamentally different way: it occurs entirely in the thin active dielectric waveguide of a GR bounded by the end reflectors of the optical resonator, while amplification occurs along the entire propagation path in the GR. In view of the foregoing, the proposed Laser may be called an "injection laser (or diode laser) with a resonant cavity."

The aforementioned essential distinctions determine the basic advantages of the proposed Lasers. The threshold current density *j*ₜₕᵣ in them can be reduced. This is due to the fact that if there are equal net losses to radiation output, defined by the factor αₒᵤₜ (relation (4)), the optical losses in the volume of a homogeneous RIR (whose composition may be selected to differ from the composition of the semiconductor layers of the heterostructure), which are characterized by the coefficient µ · α_{RIR} (cm⁻ ¹), can be made smaller than the internal optical losses in a multilayer gain region (the factor *α*_{GR}), and by selecting the Fresnel number *N* (which is equal to λ · *L*_{OR}/*n*_{RIR} · *S*_{refl}) to be much larger than one, the known diffraction losses can be made negligibly small (see relation (5), as well as A. Meitland and M. Dann, *Introduction to Laser Physics* [in Russian], Nauka Publishers, 1978, pp. 102-118).

In the proposed Lasers there are two additional possibilities for reducing the threshold current density, not only in comparison with the threshold currents of a Laser with a small outflow angle ϕ (D. R Scifres *et al*., U.S. Patent 4,063,189, 1977, H01S 3/19, 331/94.5 H) but also in comparison with the threshold currents of modern Lasers with quantum-dimensional active layers, as for example in S. S. Ou *et al.* (*Electronics Letters* (1992), Vol. 28, No. 25, pp. 2345-2346). The first possibility is related to the selection of larger outflow angles ϕ (from the range 0 < ϕ < ϕₘₐₓ), which is determined by relations (2), (6), and (7) and results in an increase in the optical radiation localization coefficient Γ, which in turn inevitably leads to an additional decrease in the threshold current densities (see, e.g., T. M. CocKerill *et al*., *Appl. Phys*. *Lett.* (1991), Vol. 59, pp. 2694-2696).

The second possibility is related to the selection of a shape of the RIR (including a solid of revolution) and a slope of its side optical surfaces or facets such that, in contrast to ordinary lasers, spontaneous radiation is involved almost entirely and from the very start in the processing of excitation of lasing.

The differential efficiency, for which the following formulae have been obtained, also can be increased in the proposed Lasers:${\text{η}}_{\text{d}} {\text{= η}}_{\text{1}} {\text{· η}}_{\text{2}} \text{,}$ where η₁ is the efficiency of output of the outgoing radiation from the GR into the RIR, equal to${\text{η}}_{\text{1}} \text{=} {\text{G}}_{\text{outflow}} \text{/(} {\text{G}}_{\text{outflow}} {\text{+ α}}_{\text{GR-thr}} \text{),}$ and η₂ is the efficiency of output of the laser radiation from the RIR, equal to${\text{η}}_{\text{2}} {\text{= α}}_{\text{out}} {\text{/(α}}_{\text{out}} {\text{+ (µ · α}}_{\text{RIR}} {\text{) + α}}_{\text{diffr}} \text{).}$

The factor α_{GR-thr} in relation (9) determines the total radiation losses in the GR, which consist of the optical radiation losses in the GR (the factor *α*_{GR}) and the losses to radiation output at the start and end of the GR (the factor α_{face}), specifically:${\text{α}}_{\text{GR-thr}} {\text{= α}}_{\text{GR}} {\text{+ α}}_{\text{face}} \text{.}$

By selecting a gain *G*_{outflow} significantly greater than α_{GR-thr}, we will obtain an efficiency η₁ (see relation (9)) close to one. Note that in D. R. Scifres *et al.* (U.S. Patent 4,063,189, 1977) the increase in the gain *G*_{outflow} is constrained by the increase in the lasing threshold current. For the proposed Lasers this constraint does not exist. If αₒᵤₜ is selected to be much larger ((µ · α_{RIR}) + α_{diffr}), the efficiency η₂ can be made close to one (see relation (10)). We will define the efficiency η as the total efficiency of the Laser without regard for losses due to electrical resistance, for which the following relation obtains:${\text{η = η}}_{\text{d}} {\text{· η}}_{\text{thr}} \text{,}$ where${\text{η}}_{\text{thr}} \text{= (1 -} {\text{j}}_{\text{thr}} \text{/} {\text{j}}_{\text{oper}} \text{),}$ and *j*ₒₚₑᵣ is the operating current density through the Laser. It follows from relations (12) and (13) that simultaneously increasing η₁ and η₂ (relation (8)) and decreasing *j*ₜₕᵣ will lead to an increase in the efficiency η.

The spatial and spectral characteristics of the laser radiation also can be improved in the proposed Lasers. This is due to the original design of the optical resonator, in which the mode of the laser radiation is basically generated in the homogeneous volume of the RIR (or of homogeneous parts thereof) in the absence of nonequilibrium majority carriers in it. In ordinary Lasers the concentration of injected carriers and the optical gain affect the value of the refractive index of the dilineated waveguide modes of the radiation, which significantly determines the instability of the spatial and spectral characteristics of injection lasers (M. Osinski *et al*., *IEEE Journ*. *of Quant*. *Electronics,* Vol. 23, 1987, pp. 9-29). In the proposed Lasers the aforementioned gain and injection processes are distributed, and they occur only on a very small part of the total optical path length. Therefore, the lasing mode of one spatial mode with respect to the transverse index in the direction parallel to the layers of the laser heterostructure (with a corresponding decrease in the angle of divergence Θ₂ in the horizontal plane) can be preserved for significantly larger dimensions of the strip than in ordinary Lasers. Consequently, the divergence of the output radiation will be significantly reduced in not only the vertical but also the horizontal plane. We shall define the horizontal plane as the plane that is perpendicular to the vertical plane and that is located on the output surfaces. In the general case, we shall define the output surfaces as the Laser surface for radiation output. Furthermore, stable generation of single-frequency laser radiation can be achieved in the proposed Lasers (over a wider range of currents), and the so-called "chirp effect" (T. L. Koch and J. E. Bowers, *Electronics Letters,* Vol. 20, 1984, pp. 1038-1039), which is undesirable for a number of applications and which determines the frequency shift of the laser radiation being generated with a change in the pumping-current amplitude, also can be reduced significantly.

Note also that the proposed Lasers have a feature that significantly simplifies the technology for making them. In [the invention of] D. R. Scifres *et al*. (U.S. Patent 4,063,189, 1977, H01S 3/19, 331/94.5 H), to eliminate undesirable losses one reflector of the optical resonator must be made with a reflective coating, and the optical facet of the RIR that is an extension thereof must be made, by contrast, with an antireflective coating. This is difficult to do in view of the micron dimensions of the reflector. Since the intensive outflow mode (*G*_{outflow} ≅ *G*_{GR}) is implemented for the proposed Lasers and since laser radiation is not generated in the GR, it is possible to simplify the technology for making them without a significant effect on output characteristics by making the angles of inclination ψ and reflection coefficients of the faces of the RIR and adjacent end surfaces the same.

The stated object also is attained by virtue of the fact that the active layer is formed of at least one sublayer, and the active layer can be implemented as one or several active sublayers, including sublayers having quantum-dimensional thicknesses separated from each other by barrier sublayers.

The cladding layers, which are respectively positioned on the first surface and opposite second surface of the active layer, are respectively formed from cladding sublayers I_{*i*} and II_{*j*}, where *i* = 1, 2,..., *k* and *j =* 1, 2,..., *m* are defined as integers that designate the sequential number of the cladding sublayers, counted from the active layer, with refractive indices *n*_{I}_{*i*} and *n*_{II}_{*j*}, respectively, and with bandgaps E_{I}_{*i*} and *E*_{II}_{*j*}, and at least one cladding sublayer is made in each cladding layer. If the active layer consists of sublayers, the cladding layers generally are made of two or more sublayers on each side of the active layer. For the case where the active layer consists of one sublayer with a thickness of approximately 50 nm or more, each cladding layer may consist of one sublayer. We consider the gradient layers used (see, e.g., [1]) to be the final number of sublayers of a cladding layer with corresponding *n*_{I}_{*i*} and *n*_{II}_{*j*} obtained by layering each gradient layer. Here, in general the refractive indices of the cladding layers usually are smaller than the refractive indices of the active sublayers. By selecting the aforementioned versions of the active and cladding layers (for the specified heterostructure) it also is possible to effect improvement of the efficiency and threshold current density, and to ensure the necessary value of *n*_{eff} (2), (6), and (7).

In the preferred embodiments, at least one of the angles of inclination ψ of the facets of the RIR with respect to the plane perpendicular to the longitudinal gain axis, called the normal plane, is greater than zero in absolute value, and the angle of inclination ψ is arbitrarily said to be positive if the facet subtends an acute angle with the inner surface (or with the active layer, which in principle is the same thing, since the output surface and the active layer are parallel to each other), and to be negative if the facet subtends an obtuse angle with the inner surface. The introduced inclined facets with specified angles of inclination ψ make it possible, by using simple technological solutions, to obtain an efficient design of an optical resonator with negative feedback, as well as different directions of laser radiation output. For some Laser designs, barrier regions are introduced into the heterostructure. The introduction of barrier regions makes it possible to make Lasers with a strip gain region (i.e., in the form of a strip of width *W*_{GR}) that have small losses of injection current to spreading, as well as multibeam Lasers.

It also is natural that to eliminate current losses the length *L*_{IRIR} of the inner surface of the RIR, which is determined along the longitudinal gain axis of the GR, and the width *W*_{RIR} of the RIR, are made to be at least of length *L*_{GR} and at least of width *W*_{GR} of the GR, respectively.

The choice of the thickness *d*_{RIR} of the RIR depends on the outflow angle ϕ, the length *L*_{GR}, and the angles of inclination and may be varied over a wide range from 2 µm to 50,000 µm or more.

Since the RIR actually is the passive volume of the optical resonator, transparency of the RIR is a necessary condition for the functioning of the proposed Laser. To obtain higher efficiency of the Laser, the RIR (or a part thereof) must be made of an optically homogeneous material, and the optical radiation losses in it (to absorption and scattering) must be much smaller than the net losses to laser radiation output from the optical resonator, specifically, the condition α_{RIR} 〈〈 αₒᵤₜ must be fulfilled, or ,${\text{α}}_{\text{RIR}} \text{〈〈 (2µ ·} {\text{L}}_{\text{GR}} {\text{)}}^{\text{-1}} \text{· ln(} {\text{R}}_{\text{1}} \text{·} {\text{R}}_{\text{2}} {\text{)}}^{\text{-1}} \text{.}$

If the RIR is made of a semiconductor material, in addition to the requirements of homogeneity, to fulfill relation (14) the RIR must have a bandgap *E*_{RIR} larger than the bandgap *E*ₐ for the active layer, which determines the waveleng λ of the laser radiation. Losses to absorption are known to decrease approximately exponentially, depending on the difference between *E*_{RIR} and *E*ₐ *(H.* C. Huang *et al*., *Journ*. *Appl. Phys.* (1990), Vol. 67, No. 3, pp. 1497-1503). To reduce the optical loss factor α_{RIR} (cm⁻¹) and consequently to attain (in addition to high differential efficiency η_{d} and low *j*ₜₕᵣ) one of the objects of the present invention - an increase in output radiation power (as a result of an increase in the effective length of the optical resonator), it is desirable for *E*_{RIR} to exceed *E*ₐ by at least 0.09 eV. In this case the optical loss factor for absorption may reach values on the order of 0.1 cm⁻¹ or less. In the general case, the RIR may be made not only of semiconductor materials. It is important only that its characteristics, particularly the refractive index *n*_{RIR} and optical loss factor α_{RIR} for absorption and scattering, meet the necessary requirements (2), (6), (7), and (14).

To simplify the technology for making the Laser, the RIR may be made of an introduced substrate on which a heterostructure is grown; furthermore, the RIR may be made electrically conductive, and in this case an ohmic contact is formed with the surface of the RIR.

In cases where the RIR becomes nonconductive, in order to obtain low values of α_{RIR} (cm⁻¹) and increase the effective length *L*_{OR} of the optical resonator and the output radiation power *P* (W) it is proposed that part of the volume of the RIR that borders on the heterostructure, of a thickness no greater than *W*_{GR} (µm), be made electrically conductive, and that the remaining volume be made of a material with an optical loss factor α_{RIR} of no more than 0.1 cm⁻¹.

Hereinafter, for brevity we shall call the part of the volume of the RIR that borders on the heterostructure and that has the specified thickness the first layer of the RIR. The other parts of the RIR may be the second layer of the RIR, which is adjacent to the first, third, and subsequent layers. It is proposed that the parts of the RIR that are layers parallel to its inner surface be made of materials with different refractive indices. In such cases, when the difference in the properties of the aforementioned layers of the RIR lies not only in electrical conductivity but also in different refractive indices, the outflow angles ϕ (2) in the layers of the RIR can be controlled, and hence the thickness of the RIR and its layers also can be controlled. It is not hard to show that the outflow angle ϕ*i* in the *i*-th layer (where i = 2, 3,..., s are integers) with a refractive index *n*_{RIR}_{*i*} is equal to arccos (*n*_{eff}/*n*_{RIR}_{*i*}) (see relation (2)). Therefore, if for example the refractive index *n*_{RIR1} of the first layer is smaller than *n*_{RIR2} for the second layer, the thickness of the second layer may be made smaller than for the first layer, and vice versa. Decreasing the thickness *d*_{RIR} may lead to simplification of the technology and to a lowering of the costs of making the RIR In both cases an ohmic contact is made with the electrically conductive part of the RIR, whose thickness it is advisable to make no greater than the width *W*_{GR} of the GR.

In Lasers whose RIR is made to have an optical loss factor α_{RIR} of no more than 0.1 cm⁻¹, it is possible to achieve a large volume of the active GR (by increasing *L*_{GR} to approximately 1 cm) with small laser-radiation losses in the RIR, and to obtain large values of the output radiation power.

In Lasers with a width *W*_{GR} of micron dimensions, to simplify the fabrication technology an ohmic contact from the direction of the RIR is made with one of the electrically conductive cladding sublayers that is located between the active layer and the RIR, preferably with the electrically conductive sublayer that has the smallest bandgap.

For those Laser designs in which, for large values of *L*_{GR}, it is undesirable to have a large thickness *d*_{RIR} (µm), it is proposed that at least one of the cladding sublayers be made with a refractive index no smaller than *n*_{RIR}. This leads to an increase in the value of *n*_{eff} and consequently to a decrease in the outflow angle ϕ (relation (2)) and in *d*_{RIR}. Small thicknesses *d*_{RIR} lead to savings of material in the RIR.

To simplify the technology for making Lasers, it is proposed that the end surface of the GR, on at least one side of the GR, be made with the same angle of inclination ψ and with the same reflection coefficient as the adjacent optical facet of the RIR. As noted previously (page 8), in practice this will not degrade the parameters of the Laser.

Different embodiments of the injection laser are proposed.

It is proposed that at least one optical facet of the RIR be made in the form of a reflector of the optical resonator and that it be formed with a positive angle of inclination ψ equal to the outflow angle ϕ, which is equal to arccos (*n*_{eff}/*n*_{RIR}), to achieve the ability to make the proposed Lasers with an outflow angle ϕ throughout the entire range of its values (2), (6), and (7), up to ϕₘₐₓ, including for values of the angles ϕ larger than the angle of total internal reflection σ, and hence to reduce the threshold current density, increase the efficiency and power, decrease the angle of divergence in the vertical plane, and effect output of laser radiation through the optical facet of the RIR when [the radiation is] normally incident on it [the optical facet].

For the same purposes, but with implementation of laser radiation output perpendicular to the plane of the active layer, at least one optical facet is formed with a negative angle of inclination ψ equal to (π/4) - (ϕ/2), and at least part of the outer surface of the RIR is made, at least at the point of projection onto it of the formed optical facet of the RIR, in the form of a reflector of the optical resonator, or at least one optical facet of the RIR is formed with a positive angle of inclination ψ equal to (π/4) + (ϕ/2), and at least part of the Laser surface opposite the RIR is made, at least at the point of the projection onto it of the formed optical facet of the RIR, in the form of a reflector of the optical resonator. In the first case, radiation output will occur through the outer surface of the RIR, and in the second case it will occur in the diametrically opposite direction.

In a number of other cases, in the aforementioned embodiments of the proposed Lasers the other optical facet of the RIR is formed with an angle of inclination ψ of zero. A reflective coating is made on the aforementioned optical facet of the RIR (when the angle ϕ is less than the angle of total internal reflection a on the output surface). This leads to one-way output of laser radiation, and also to a decrease in the length *L*_{GR} and in the angle of divergence Θ₁ of the output laser radiation in the vertical plane.

To enhance the spatial and spectral characteristics of the Laser, it is advisable that at least one of the reflectors of the optical resonator be made in the form of an external reflector.

If the angle ϕ is smaller than the angle σ, the use of an external reflector (outside the RIR) makes it possible to create a proposed Laser in which both facets of the RIR subtend an angle of inclination ψ equal to zero. This simplifies the technology for making the Laser, since there is no need to make the facets for the RIR sloped. In this case, negative feedback is generated by using an external reflector (or reflectors) made with the corresponding angle of inclination.

It is possible to make one of the reflectors of the optical cavity, which is formed either on the external reflector, or on the output surfaces of the RIR or heterostructure, in the form of a plane mirror, or in the form of a cylindrical mirror, or in the form of a spherical mirror, or in the form of a diffraction grating.

Embodiments of the proposed Laser also are possible in which an additional lowering of the threshold current (with a corresponding increase in the efficiency η) is effected through more complete utilization of spontaneous radiation in developing the process of lasing excitation. In a number of cases, this is attained by virtue of the fact that at least one of the introduced side optical facets (hereinafter referred to as "a side facet") of the radiation-inflow region is made sloped with an angle of inclination β relative to the vertical plane that is perpendicular to the active layer and that passes through the longitudinal gain axis, and the angle of inclination β is said to be positive if the side facet subtends an acute angle with the inner surface, and to be negative if it subtends an obtuse angle therewith.

To obtain a larger effect, a reflective coating is made on at least one side facet of the RIR, and it [this facet] is formed with a positive angle of inclination β equal to the outflow angle ϕ, or
at least one side facet of the RIR is formed with a negative angle of inclination β equal to the angle (π/4 - ϕ/2), and a reflective coating is made on at least part of the outer surface of the RIR, in at least part of the projection onto it of the formed side facet of the RIR, or
at least one side facet of the RIR is formed with a positive angle of inclination β equal to the angle (π/4 + ϕ/2), and a reflective coating is made on at least part of the surface of the Laser opposite the RIR, in at least part of the projection onto it of the formed side facet of the RIR.

The largest effect in reducing the threshold current density, and the unusual form of the radiation near field, in the form of a luminous ring, or a part thereof, can be obtained in proposed Lasers in which the RIR is formed as at least one truncated right circular cone, one of whose bases is the inner surface, and a reflector of the optical resonator is disposed on at least part of the output surface. Here, if a reflective coating is made on at least part of the output surface, a reduction of the size of the radiation near field can be effected.

The output laser radiation will be inclined at an angle ϕ to the plane of the active layer if the angles of inclination y of the generatrices of the side surface of the cone with its inner surface are selected to be (π/2 - ϕ).

The laser radiation will emerge through the outer surface of the RIR at a right angle to the plane of the active layer if the angles of inclination y of the generatrices of the side surface of the cone with its inner surface are selected to be (3π/4 - ϕ/2).

The laser radiation will emerge at a right angle to the plane of the active layer, but in the opposite direction, if the angles of inclination y of the generatrices of the side surface of the cone with its inner surface are selected to be (π/4 - ϕ/2).

Note that it is accepted practice (I.I. Bronshtein and K. A. Semendyayev, *Handbook of Mathematics* [in Russian], p. 170, 1953) to measure the angles of inclination ψ and β formed between two half-planes (a facet and the inner surface) as the angle between two perpendiculars drawn in both half-planes from one point on the line of their intersection. If the RIR is made of a truncated right circular cone, the angle of inclination γ is measured between the generatrix of the cone and the perpendicular drawn on the inner surface from the points of its intersection with the generatrix. Here, the angle is calculated from the inner surface. The accuracy with which the angles of inclination ψ, β, and γ must be made are determined by the dispersion angle of divergence Δϕ (the diffraction angle of divergence may be ignored because of its smallness in comparison with the angle Δϕ), which is determined by the spread of the outflow angle ϕ as a function of the wavelength λ, which varies over the range of the spectral band Δλ for spontaneous radiation. We determined the angle Δϕ by a numerical calculation using relation (2) for the known dependences of *n*_{eff} and *n*_{RIR} on λ in the range Δλ. The calculations showed that for the most frequently used heterostructures with Δλ of 20-50 nm, the angle Δϕ lies in the range from 0.5° to 1.5°.

Embodiments of the Lasers also have been proposed whose designs include two or more (a multiplicity of) gain regions.

A peculiarity of one embodiment of a multibeam Laser is that at least two gain regions are formed with identical outflow angles ϕ on the inner surface of at least one RIR. The gain regions, which often (but not necessarily) have a rectangular shape, are positioned with specified periods, including those in a mutually perpendicular direction. In a number of cases, an independent ohmic contact is made with each GR from the direction opposite the location of the RIR. Such a Laser using an output reflector of the RIR will have a multiplicity of laser beams, including beams that are spatially separated from each other and that can be turned on independently by the operating current.

In another embodiment of a multibeam Laser, a multiplicity of laser beams forms a two-dimensional matrix in which each beam is independently controllable by the operating current. In it the gain regions are formed from at least two sequences of GRs in each of which at least two GRs are disposed so that the gain axes of each GR in each sequence are parallel to each other and are positioned at a right angle to the line of intersection of the active layer with the extension of the plane of the facet of the common RIR for each sequence of GRs. Furthermore, from the direction of the RIR, on at least part of the outer surfaces of the aforementioned common RIRs, ohmic contacts and metallization layers to them are made in the form of strips, at least of the metallization layers, for each aforementioned sequence of GRs. From the direction opposite the location of the RIR, the metallization layers to the independent ohmic contacts are made in the form of strips that are insulated from each other and that are positioned parallel to the gain axes of the GRs.

A peculiarity of the next embodiment of a Laser with several GRs is that they are successively connected into a unified optical resonator. In this case, the GRs are formed along at least one line parallel to the longitudinal gain axes of the GRs; the spacing between the starts of the GRs are selected to be 2*d*_{RIR}/tan ϕ, and the outer surface is made optically reflective, at least at points of the projection onto it of the gain regions at the outflow angle ϕ. It also is possible to form on opposite surfaces, for at least one GR having identical outflow angles ϕ, RIRs along two lines that are parallel to each other and to the longitudinal gain axes of the GRs; here, the shortest distance between the starts of the GR on opposite sides of the RIR is selected to be *d*_{RIR}/sin ϕ. These modifications make it possible to increase the radiation output power while at the same time reducing the thickness of the RIR and improving the conditions of heat removal.

It is proposed that, in Lasers with either one or a multiplicity of gain regions, the gain region or at least two adjacent GRs be galvanically isolated all the way to the nonconductive part of the volume of the RIR, and that the ohmic contacts of the aforementioned gain regions be galvanically coupled by a metallization layer. This makes it possible to increase the value of the supply voltage and to perform effective matching of the proposed Lasers to power sources.

The essence of the present invention is an original design of an optical resonator the volume (bulk) of whose medium includes not only an active layer but also the volume of the gain region with intense outgoing radiation, as well as the passive volume of the radiation inflow region, which are formed with appropriately made compositions, thicknesses, number of layers of the laser heterostructure, configuration of the radiation inflow region and its optical facets, ohmic contacts, and metallization layers, which made possible practical delimitation of the region of generation of laser-radiation modes and the region of injection and stimulated recombination of nonequilibrium carriers.

The aggregate of the essential characteristic features of the proposed Lasers according to the claims determined their main advantages. The decrease in the threshold current density, increase in efficiency (including differential efficiency), improvement of astigmatism and production of small angles of divergence close to the diffraction angles for two mutually perpendicular directions of output radiation, including an increase in the stability of monomode lasing, a significant decrease in the dependence of the wavelength of the generated laser radiation on the pumping-current amplitude, and the ability to increase the effective length of the optical resonator and radiation output power are due to the main distinction of the proposed Lasers ― the rejection of the traditional dielectric waveguide with an active layer inside, as a lasing medium generating delineated waveguide modes. Additional advantages of the proposed Lasers are the ability to obtain different directions of laser radiation, including those perpendicular to the plane of the active layer, as well as increased service life and operational reliability and high manufacturability. An advantage of the proposed. Lasers with a multiplicity of gain regions, in addition to those mentioned previously, is the integrated technology for making them.

The technical implementation of the invention is based on known basic production processes, which by now are well developed and are used extensively in laser manufacture. The range of radiation wavelengths of the Lasers that have been put to use to date extends from the infrared to the ultraviolet. Depending on the wavelength, appropriate heterostructures are used for different sections of the wavelength range. For example, heterostructures based on semiconductor compounds in the AlGaN/GaN/GaInN system, and also [in the] ZnCdSSe/GaAS [system], are most effective for ultraviolet, blue, and green radiation (0.36 µm < λ < 0.58 µm); compounds in the AlGaInP/GaAs system [are most effective] for red and yellow (0.58 µm < λ < 0.69 µm); compounds in the AlGaAs/GaAs system and in the InGaAs/GaAs/AlGaAs system [are most effective] for infrared (0.77 µm < λ < 1.2 µm); compounds in the GaInAsP/InP system [are most effective] for infrared (1.2 µm < λ < 2.0 µm); and compounds in the AlGaInSbAs/GaAs system [are most effective] for infrared (2.0 µm < λ < 4.0 µm). In each of the aforementioned ranges, appropriate materials for the RIR that satisfy conditions (2), (6), (7), and (14) must be selected, depending on the wavelength λ used and the heterostructure chosen. Among semiconductor materials for RIRs, we can propose: GaN for the AlGaN/GaN/GaInN system; ZnSe for the ZnCdSSe/GaAs system; GaP for the AIGaInP/GaAs system; GaP for the AlGaAs/GaAs system; GaAs and GaP for the InGaAs/GaAs/AlGaAs system; Si and GaAs for the GaInAsP/InP system; and Si and GaAs for the AlGaInSbAs/GaAs system. These proposals can be successfully implemented by using the recently developed "plate attachment" technology (see, e.g., H. Wada *et al*., *IEEE Photon. Technol. Lett.,* Vol. 8, p. 173 (1996)). The designs proposed in the present invention for efficient injection Lasers are applicable for at least all the aforementioned ranges of laser-radiation wavelengths and heterostructure systems.

### Brief Description of the Drawings

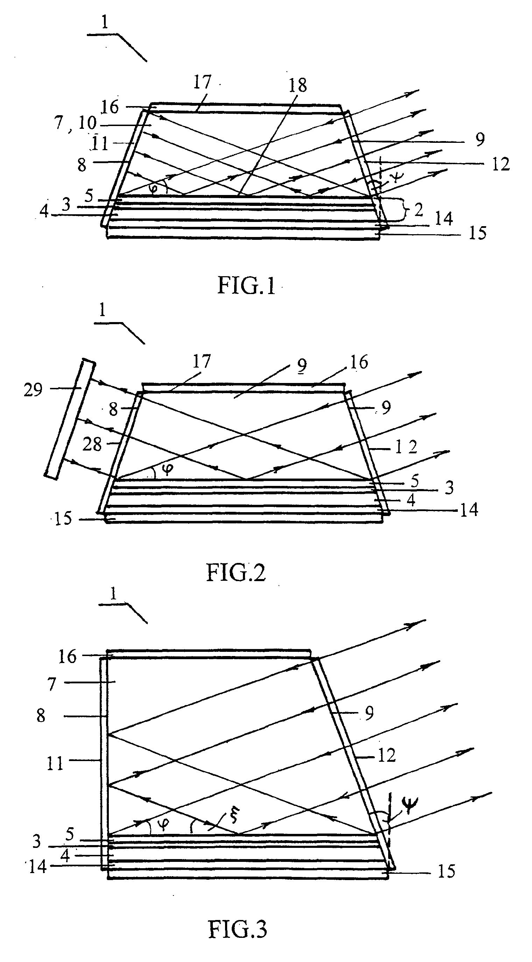

The present invention will be understood from Fig. 1-26.
Figs. 1-7 schematically depict longitudinal sections (along the optical gain axis of the GR) of different designs of the proposed Laser with GR end surfaces made in the form of planes that extend the planes of the corresponding facets, with one-way radiation output, specifically:
   in Figs. 1-3 ― with facets of the RIR that are implemented as reflectors of the optical resonator, and
   in Fig. 1 ― with two inclined facets with a positive angle of inclination ψ equal to ϕ,
   in Fig. 2 ― with an external reflector in the form of a plane mirror to one of the inclined facets,
   in Fig. 3 ― with one facet with an angle of inclination ψ equal to zero;
   in Figs. 4-7 ― with parts of the outer surface of the RIR that are implemented as reflectors of the resonator, and

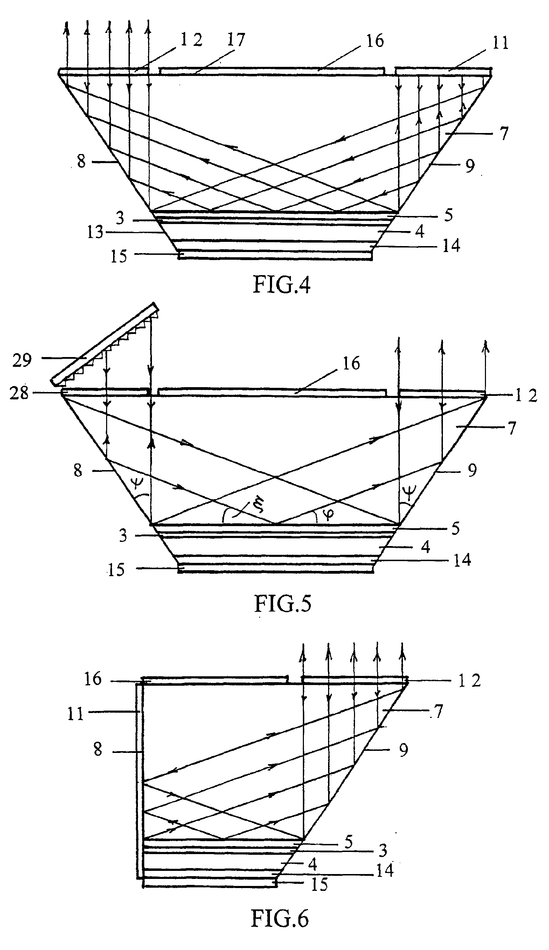

   in Fig. 4 ― with two inclined facets of the RIR with negative angles of inclination ψ equal to (π/4 - ϕ/2),
   in Fig. 5 ― with an external reflector in the form of a diffraction grating to one of the inclined facets;
   in Fig. 6 ― with another facet with an angle of inclination ψ equal to zero;

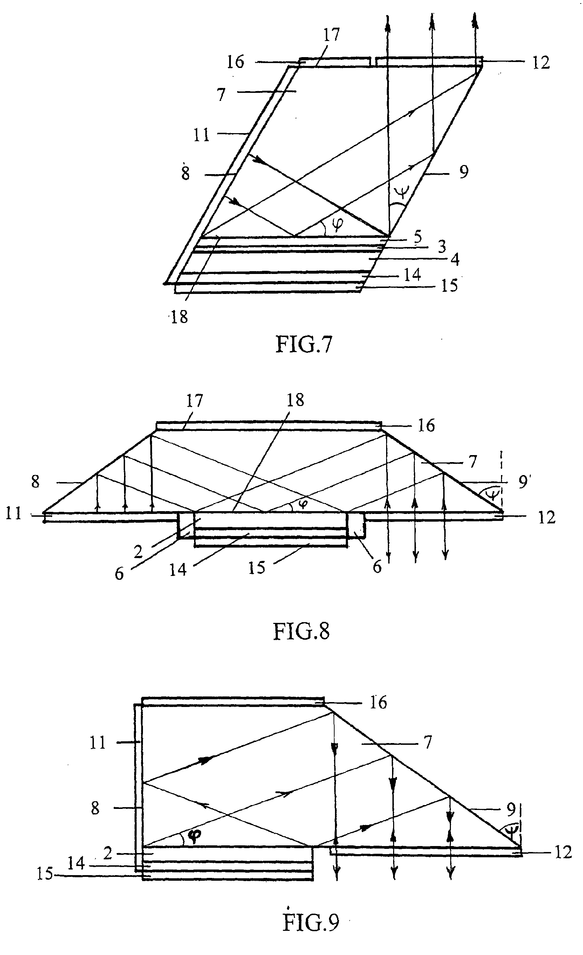

   in Fig. 7 ― with one inclined facet of the RIR with a positive angle of inclination and another inclined facet with a negative angle of inclination.
Figs. 8-9 schematically depict longitudinal sections of designs with parts of the outer surface of the heterostructure that are implemented as reflectors of the optical resonator, and
   in Fig. 8 ― with two inclined facets with angles of inclination ψ equal to (π/4 + ϕ/2);
   in Fig. 9 ― with one inclined facet with an angle of inclination ψ equal to (π/4 + ϕ/2), and the other with an angle of inclination ψ equal to zero.

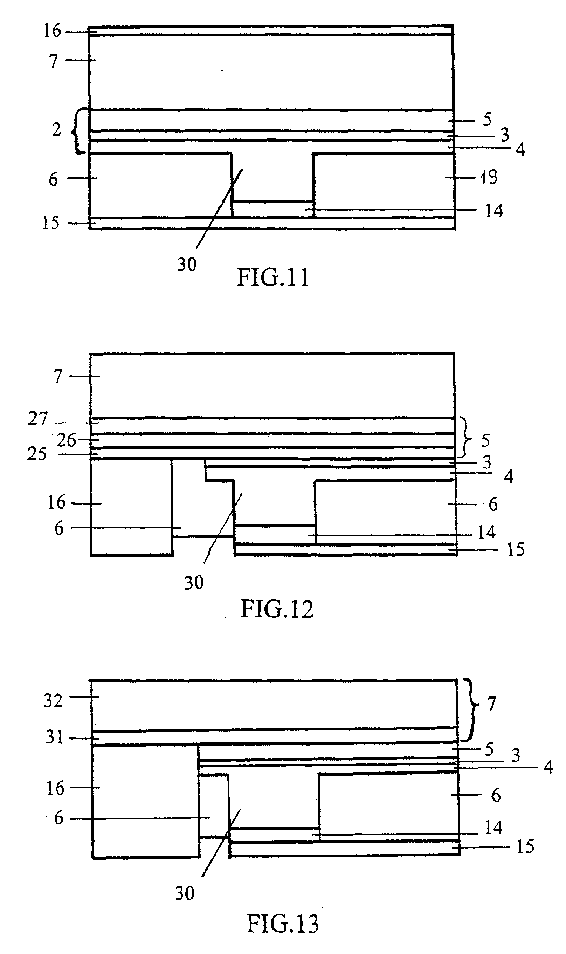

Fig. 10 schematically depicts a longitudinal section of the design of the proposed Laser with two facets with angles of inclination ψ equal to zero, and with outer inclined reflectors in the form of plane mirrors.
Figs. 11-13 schematically depict cross-sections of some designs of the proposed Laser according to different implementations of the ohmic contact from the direction in which the RIR is located:
   in Fig. 11 ― on the outer surface of the RIR,
   in Fig. 12 ― on the electrically conductive sublayer of the cladding layer adjacent to the RIR, and
   in Fig. 13 ― on the electrically conductive part (layer) of the RIR adjacent to the heterostructure.

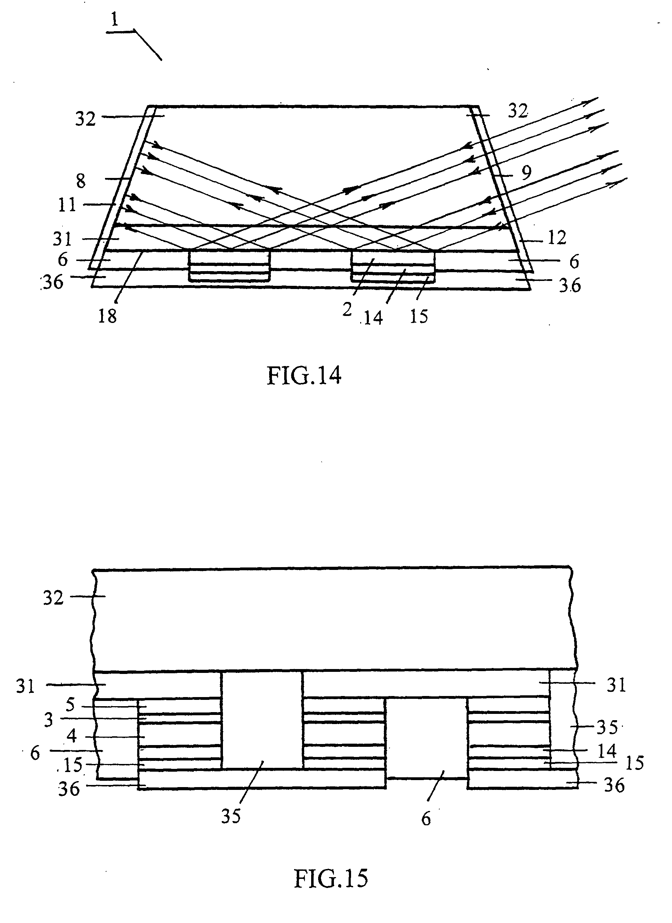

Figs. 14-15 schematically depict a longitudinal section (Fig. 14) and cross-section (Fig. 15) of the proposed Lasers with six GRs that are galvanically series-parallel connected, with a single RIR.

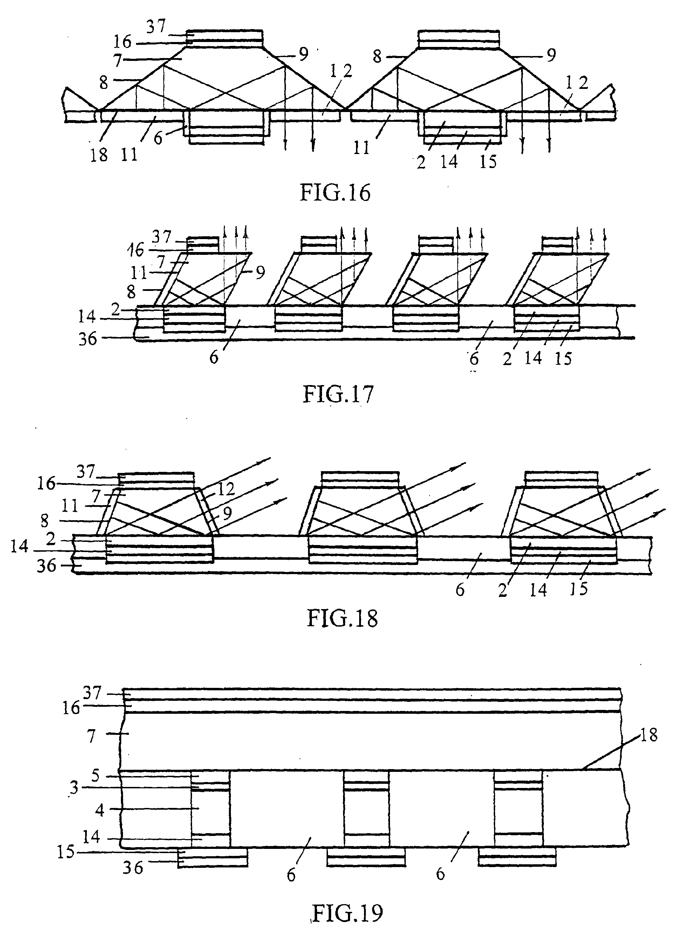

Figs. 16-18 schematically depict longitudinal sections, and Fig. 19 a cross-section, of the proposed Laser with a multiplicity of GRs independently galvanically controllable, with separate RIRs for three different sequences of GR, to wit:
   in Fig. 16 ― with two inclined facets of the RIR with positive angles of inclination (see Fig. 9) and output of laser radiation in the direction perpendicular to the plane of the active layer,
   in Fig. 17 ― with one inclined facet of the optical resonator with a positive angle of inclination and a second inclined facet with a negative angle of inclination (see Fig. 8) and with output of laser radiation in the direction perpendicular to the plane of the active layer;
   in Fig. 18 ― with two inclined facets of the RIR with positive angles of inclination (see Fig. 1) and with output of laser radiation at an angle ϕ to the plane of the active layer.

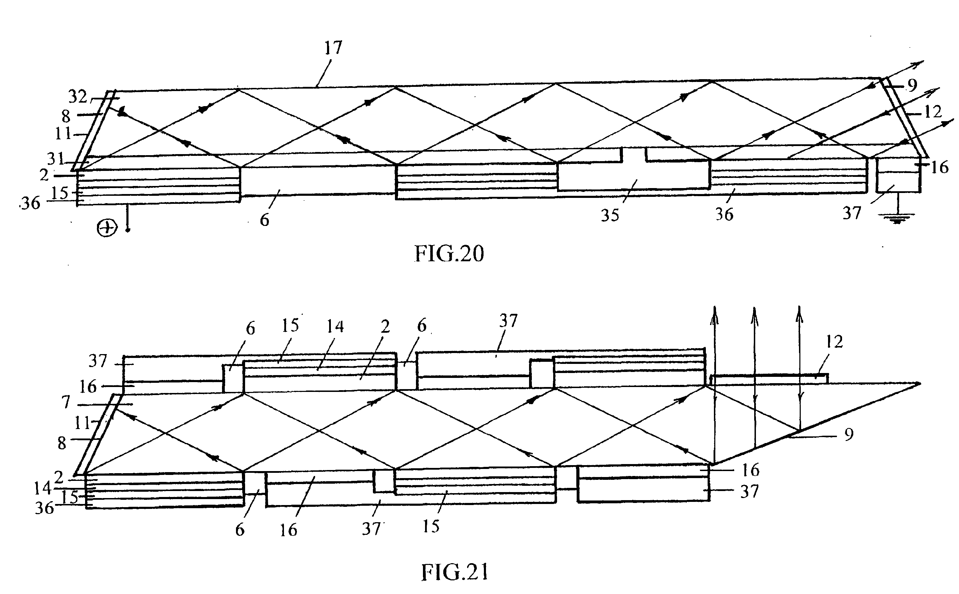

Figs. 20-21 schematically depict longitudinal sections of the proposed Laser, with GRs that are galvanically series connected and that are disposed along their own gain axes and to a separate RIR, and
   in Fig. 20 ― with the placement of three GRs on one surface of the RIR,
   in Fig. 21 ― with the placement of four GRs on two opposite surfaces of the RIR.

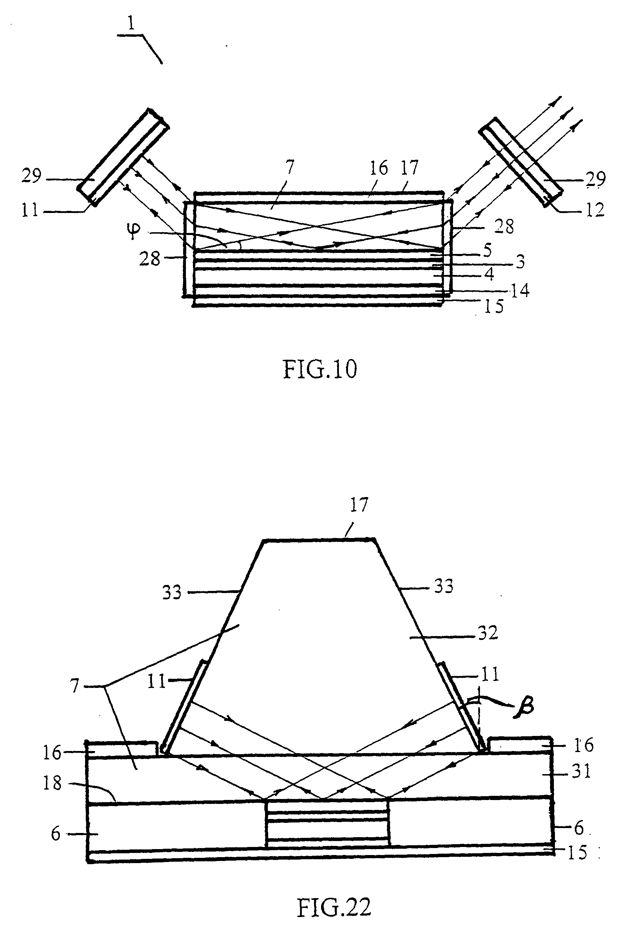

Fig. 22 schematically depicts a cross-section of the designs of Lasers (longitudinal sections of which are presented in Figs. 1-10) with a two-layer RIR made with two inclined side optical facets for the second layer of the RIR having positive angles of inclination β equal to ϕ.

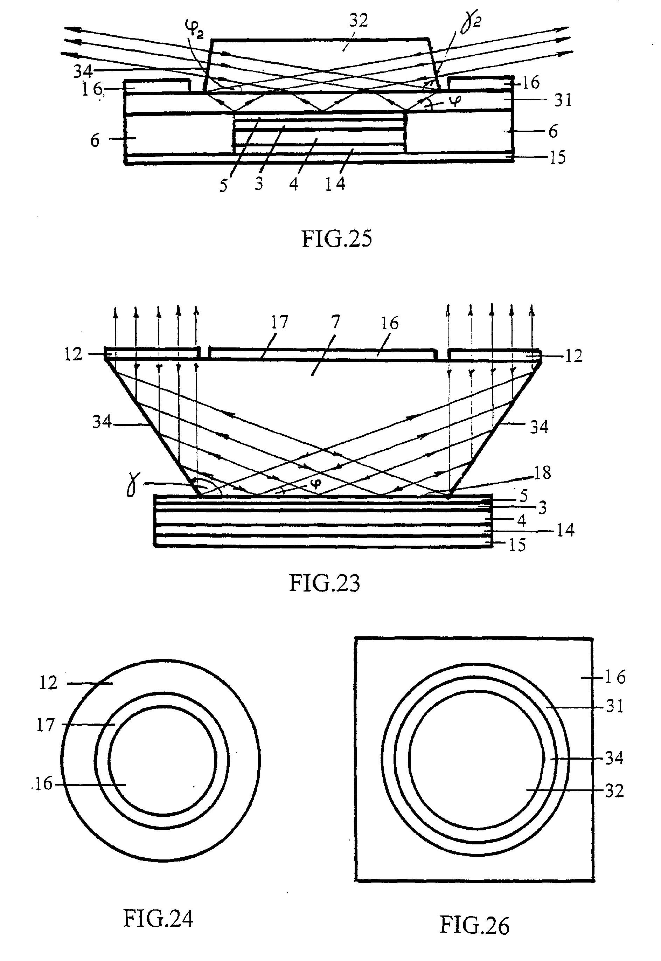

Figs. 23-26 schematically depict sections in the plane of symmetry (Figs. 23 and 25) and top views (Figs. 24 and 26) for Lasers whose RIR is implemented as a right truncated circular cone, with angles of inclination y of the generatrices of the side surface of the cone with its base, which is the inner surface, that are equal:
   to (3π/2 - ϕ/2) in Figs. 23 and 24, and
   to (π/2 - ϕ) in Figs. 25 and 26.

### Embodiments of the Invention

Hereinafter, the invention is explained through specific embodiments of it, with references to the attached drawings. The adduced examples of the design of the Radiator are not unique, and imply the existence of other embodiments whose features are reflected in the aggregate of the features in the claims.

The proposed Laser 1 (see Fig. 1 and Fig. 11) includes a heterostructure 2, which comprises an active layer 3 positioned between two cladding layers 4 and 5, respectively, with sublayers I_{*i*} and II_{*j*} (not shown in Fig. 1). Active layer 3 consists of two active sublayers and a barrier sublayer that separates them (not shown in Fig. 1). The length of the *L*_{GR} is 4000 µm. The length of the optical resonator *L*_{OR} is 3760 µm (see relation (1)), and the ratio µ (relation (1)), is equal to 0.9397. The width *W*_{OR} in the form of a strip (or mesa strip) bounded on the sides by barrier regions 6 is 400 µm. The total width of the laser crystal is 1000 µm. A semiconductor RIR 7, bounded on the end faces by facets 8 and 9, which are implemented as reflectors of the optical resonator, is located on the surface, distant from active layer 3, of sublayer II_{*m*} of cladding layer 5. RIR 7 is implemented as a substrate 10 to which the required form is imparted. Both facets ― the first facet 8 and second facet 9 ― of RIR 7 are made inclined with a positive angle of inclination ψ equal to the outflow angle ϕ, which is 20°. The angle is calculated from the normal plane, which is perpendicular to the longitudinal gain axis in the GR. If the angle of inclination ψ is positive, facets 8 and 9 subtend an acute angle with active layer 3. A reflective coating 11 with a reflection coefficient *R*₁ of 0.999 is formed on the first facet 8, and a partially reflective coating 12 with a reflection coefficient *R*₂ of 0.01 is formed on the second facet. The end surfaces 13, which determine the length of the gain region *L*_{GR}, are an extension of the corresponding planes of the inclined facets 8 and 9 and have the same inclinations and the same reflection coefficients as facets 8 and 9. This simplifies the fabrication technology. This simplification does not have any practical effect on the parameters of Laser 1, since strong outflow is realized in the proposed Laser 1, and there is practically no laser radiation through end surfaces 13. The accuracy with which the facets 8 and 9 were inclined was kept in the range from 17.6° to 18.4°. The thickness *d*_{RIR} of RIR 7, for which the relation${\text{d}}_{\text{RIR}} \text{≥ (} {\text{L}}_{\text{IRIR}} {\text{· tan ϕ/(1 + tan}}^{\text{2}} \text{ϕ)),}$ is fulfilled, is 1,286 µm. Contact layer 14 is positioned on the surface of sublayer I_{*k*} of cladding layer 5, and an ohmic contact 15 is formed on it. An ohmic contact 16 is made on the opposite side of RIR 7, on its outer surface 17 of RIR 7 (in this case, on the surface of substrate 10). Inner surface 18 borders on heterostructure 2, and is parallel to the plane of active layer 3.

Heterostructure 2, which consists of a number of semiconductor layers and sublayers 19-27, together with contact layer 14, was grown by the known method of MOS-hybrid epitaxy on substrate 10 from electrically conductive gallium arsenide. The composition, thicknesses, refractive indices, type, doping concentrations, and absorption coefficients of layers 19-27 of heterostructure 2, contact layer 14, and RIR 7 are presented in the Table. This heterostructure 2 also was used in the following embodiments (with the changes specified for the separate embodiments). The radiation wavelength for this heterostructure 2 is 980 nm. In Fig. 1 and in subsequent figs. 2-10, 14, 16-18, 20-23, and 25, conventional arrows show the directions of propagation of laser radiation in RIR 7 and outside it. Laser 1 was mounted on a thermally conductive slab (not shown in figs. 1-26) with the side of ohmic contact 15. The required power was supplied to ohmic contacts 15 and 16.

The basic parameters for both the Laser in question, Laser 1, and subsequent modifications of it were obtained by numerical modeling performed according to a special program underlying which was the matrix method (J. Chilwall and I. Hodkinson, *Journ*. *Opt. Soc*. *Amer*., A (1984), Vol. 1, No. 7, pp. 742-753) of solving Maxwell's equations with the corresponding boundary conditions in multilayer laser heterostructures. The calculations used the following initial parameters: the material gain in active layer 3 needed to achieve inversion is 200 cm⁻¹, the proportionality factor between the gain and injected-electron concentration in active layer 3 is 5 × 10⁻¹⁶cm², and the lifetime of the nonequilibrium electrons in active layer 3 is 1 ns.

The calculations also assumed: an optical loss factor α_{GR} in the GR of 3 cm⁻¹ (see D. Z. Garbuzov *et al*., *IEEE Journ*. *of Quant*. *Electr*. (1997), Vol. 33, No. 12, pp. 2266-2276) and in accordance, for example, with H. C. Huang *et al*. (*Journ*. *Appl. Phys.* (1990), Vol. 67, No. 3, pp. 1497-1503), and with a value of the optical loss factor α_{RIR} of the laser radiation in RIR 7 of 0.1 cm⁻¹. The losses to output of spontaneous radiation through end surfaces 13 of the gain region were not taken into account in the calculations because of their smallness, so that α_{GR-thr} (relation (11)), is 3 cm⁻¹. The values adopted for the parameters are typical of the laser heterostructure 2 in question, which is based on InGas/GaAs/AlGaAs. If one turns to a heterostructure 2 using other compounds, such as GaInPAs/InP, these parameters may change somewhat.

The following results were obtained by numerical calculation:
- the threshold current density *j*ₜₕᵣ is 89.3 A/cm² (relation (3) is fulfilled for this current density);
- the outflow angle ϕ is 20°;
- the dispersion angle of divergence Δϕ for the outgoing spontaneous radiation (for the Δλ of 30 nm used in the calculation) was found to be 0.8° (see page 14);
- the effective refractive index *n*_{eff} is 3.3124;
- the total gain *G*_{GR} and gain *G*_{outflow} for the outgoing radiation (reached for a current density *j*ₒₚₑᵣ of 2,500 A/cm² through Laser 1) are 320.80 cm⁻¹ and 320.03 cm⁻¹, respectively; here the difference (*G*_{GR} - *G*_{outflow}), which is 0.73 cm⁻¹, is smaller than α_{GR-thr} (relation (11)), which is 3 cm⁻¹, which means that the mode of intensive outflow has been selected, and that lasing did not occur in the GR (see page 5);
- the net loss factor αₒᵤₜ (relation (4)), for the output laser radiation from RIR 7 is 11.515 cm⁻¹;
- the optical loss factor, defined as µ · α_{RIR}, is 0.09397 cm⁻¹;
- the threshold loss factor *α*_{RIR}_{*-*}ₜₕᵣ (relation (3)), in RIR 7, defined as the sum (αₒᵤₜ + (µ · cos ϕ) + *α*_{diffr}), is equal to 11.609, and the α_{diffr} calculated from relation (5) is negligibly small;
- the area of the gain region *S*_{GR} is 1.6 × 10⁻² cm²;
- the threshold current *J*ₜₕᵣ, defined as (*j*ₜₕᵣ · *S*_{GR}), is 0.8 A;
- the differential efficiency η_{d} is 0.9827 (see relation (8)), and its components η₁ (relation (9)) and η₂ (relation (10)) are 0.9907 and 0.9919, respectively; and
- the threshold loss factor ηₜₕᵣ (relation (13)) for a *j*ₒₚₑᵣ of 2,500 A is 0.9643, and the efficiency η (relation (12)) of Laser 1 is 0.9476.

The output power *P* (W) of laser radiation is determined as:$\text{P} \text{= η ·} \text{J} \text{· (} \text{h} \text{ν),}$ where *J* is the operating current through the device, equal to 40 A, and (*h*ν) is the photon energy in volts, equal to 1.265 V. The value obtained for *P* is 47.95 W. The radiation near-field area (output aperture) *S*ₐₚ, defined as (*d*ₐₚ · *W*_{GR}), is equal to 0.51 × 10⁻² cm², where *d*ₐₚ is equal to *L*_{GR} · sin ϕ, specifically 1,368 µm, and *W*_{GR} is 400 µm. The angles of divergence Θ₁ and Θ₂ of the output radiation were respectively estimated as the wavelength λ, divided by *d*ₐₚ, and the wavelength λ, divided by *W*_{GR}. In the vertical plane, the angle Θ₁ was found to be 0.72 mrad. In the horizontal plane the angle Θ₂ is 2.45 mrad in the range of currents for which monomode lasing is maintained. The output of laser radiation on the output facet 9, defined as *P/S*ₐₚ, is 9402 W/cm².

Another embodiment of Laser 1 (see Fig. 2) differed from the first one in that an antireflective coating 28 was applied to facet 8, and outer reflector 29 was implemented as a plane mirror measuring 2,500 × 2,500 µm², with a reflection coefficient of 0.999, which was parallel to facet 8 and 10,000 µm from it. The width *W*_{GR} was 1,368 µm, and the total width of the laser crystal was 3,000 µm. The basic parameters of Laser 1 in this embodiment that differ from the first embodiment are: *S*_{GR}, *J*ₜₕᵣ, *J*ₒₚₑᵣ, *P* (relation (16)), and *S*ₐₚ are respectively equal to 5.47 × 10⁻² cm², 1.43 A, 136.75 A, 163.9 W, and 1.87 × 10⁻² cm², and Θ₁ and Θ₂ are identical and are equal to approximately 0.72 mrad.

The difference between the embodiment of Laser 1 (see Figs. 10 and 11) and the previous one is that facets 8 and 9 of RIR 7 were made with an angle of inclination ψ of zero. As a result of the increase in the thicknesses of layers 21 and 25 of heterostructure 2 (see Table), the outflow angle ϕ was reduced to 12°, which is smaller than the angle σ. Here, the plane of external reflectors 29 for providing negative feedback was adjusted with an angle of inclination relative to the normal plane of 42.3°, and the angle Δϕ was 1.4°. Laser 1 had unidirectional radiation output, ' since one reflector had a reflective coating 11 with *R*₁ of 0.999, and the other had a coating 12 with *R*₂ of 0.05. In addition to the known advantages inherent in Lasers with an external resonators (in particular, the enhancement of spatial and spectral characteristics), another advantage of it is a simplification of the fabrication technology.

The next embodiment of Laser 1 (see Fig. 4 and Fig. 11) differed from the first one in that both facets 8 and 9 of RIR 7 were made with a negative angle of inclination ψ equal to (π/4 - ϕ/2), specifically 35°. The length *L*_{RIR} was 1,000 µm and the width *W*_{GR} was selected to be 340 µm. The thickness *d*_{RIR} of RIR 7 was 500 µm, and its length *L*_{ORIR} was 1,700 µm. A reflective coating 11 with a reflection coefficient *R*₁ of 0.999 was formed on the outer surface 17 at the point of the projected of facet 8 onto it, and a partially reflective coating 12 with a reflection coefficient *R*₂ of 0.02 was formed at the point of the projection of the other facet 9. The length *L*_{OR} of the optical resonator, defined as µ · *L*_{GR} (relation (1)), was 1,940 µm, and the ratio µ = 1.94. The following parameters were obtained for this embodiment of Laser 1:
- the threshold current density *j*ₜₕᵣ is 42 A/cm²;
- the loss factors αₒᵤₜ and µ · α_{RIR} are 3.913 cm⁻¹ and 0.194 cm⁻¹, respectively;
- the α_{diffr} calculated from relation (5) is negligibly small, and consequently α_{RIR-thr} (relation (3)) is 4.107 cm⁻¹;
- the efficiencies η₁, η₂, *η*_{*d*}, *η*ₜₕᵣ, and η are respectively 0.9907, 0.958, 0.9439, 0.9832, and 0.9280;
- the threshold current *J*ₜₕᵣ is 0.143 A for an *S*_{GR} of 0.34 x 10⁻² cm²; and
- the operating current *J*ₒₚₑᵣ is 8.5 A (for a *j*ₒₚₑᵣ of 2500 A/cm²), and the output power *P* (relation (16)) of Laser 1 under conditions of a single spatial mode is 9.98 W, while the angles of divergence Θ₁ and Θ₂ are identical and are equal to 2.8 mrad.

The embodiment of Laser 1 in Figs. 5 and 11 differs from the previous one in that one of the reflectors of the optical resonator is external 29 and is implemented as a reflective diffraction grating. This makes it possible to achieve a single-frequency lasing operation.

The embodiment of Laser 1 in Figs. 8 and 11 is distinctive in that both facets 8 and 9 are inclined at a positive angle ψ equal to (π/4 + ϕ/2), specifically 55°, and the output radiation is directed at a right angle to the plane of active layer 3 in the direction of heterostructure 2. The GR, of width 15.3 µm and length 45 µm, is located in the middle of inner surface 18, whose width *W*_{IRIR} is 25 µm and whose length *L*_{IRIR} is 135 µm. Coatings 11 and 12, whose reflection coefficients are 0.999 and 0.90, respectively, are applied to the inner surface 18 at the points of projection of facets 8 and 9. A barrier region 6 is formed on the remaining area of inner surface 18, which is free of heterostructure 2 and coatings 11 and 12. The thickness of RIR 7 was 23 µm, the length of the outer surface 17 was 73.8 µm, and the length *L*_{OR} of the optical resonator was 129 µm. The aforementioned design changes determined the following parameters: *j*ₜₕᵣ is 125 A/cm², and αₒᵤₜ, α_{diffr}, µ, and (µ · α_{RIR}) are respectively 11.7 cm⁻ ¹, 4.22 cm⁻¹, 2.86, and 0.286 cm⁻¹, and consequently α_{GR-thr} is 16.2 cm⁻¹, the threshold current *J* is 0.861 mA, the operating current *J*ₒₚₑᵣ was selected to be 13.8 mA, the output power *P* (relation (16)) of the laser radiation is 11.66 mW, and η_{d} (relation (8)) is 0.7139 and η (relation (12)) is 0.6693. This Laser 1 generates in a single longitudinal mode, its wavelength is practically independent of the pumping current over a wide range thereof, and the angles of divergence Θ₁ and Θ₂ are identical and are equal to 6.4 mrad (0.37°). This embodiment, in addition to the others (see Figs. 4 and 6-9) is competitive with Lasers with a vertical resonator that are now being studied extensively (B. Weigl *et al*., *Electronics Letters,* Vol. 32, No. 19, pp. 1784-1786, 1996).

The embodiment of Laser 1 in Figs. 7 and 11 differs from the three previous ones in that the facets 8 and 9 are made different in sign but identical in absolute value of the angle of inclination ψ, which is 30°. This makes it possible to obtain output radiation directed at a right angle to the plane of active layer 3, but for smaller values of the ratio µ (relation (1)) than in the previous examples.

What is common to the embodiments of Lasers 1 in Fig. 3, Fig. 6, and Fig. 9 is that facet 8 of RIR 7 is made with an angle of inclination ψ of zero. For the embodiments of Lasers 1 in accordance with Fig. 1, Fig. 4, and Fig. 8, this leads (provided that the lengths *L*_{GR} are kept the same) to a doubling of the linear size of the radiation output aperture, with a corresponding decrease in the angle of divergence Θ₁ in the vertical plane.

In the embodiments of the Lasers in Figs. 1-10, mesa strip 30, which determines the dimensions of the GR, may be made of a specified width by using barrier regions 6 (see Figs. 11-13). For a Laser 1 with a mesa strip 30 with a width of micron size, ohmic contact 16 can be made, for example, with sublayer 25 of cladding layer 5, as shown in Fig. 12. In this case RIR 7 may be an insulating region, which facilitates the selection of RIR 7 with a small coefficient α_{RIR}. If a two-layer RIR 7 consisting of a first electrically conductive layer 31 and a second insulating layer 32 is present, ohmic contact 16 is made with the first layer 31 (Fig. 13). In this case, the second layer 32 of RIR 7 may be not only an insulating layer, but also a layer that differs in composition from first layer 31, which also facilitates the selection of both small values of α_{RIR2} and corresponding thicknesses *d*_{RIR2} of layer 32, provided that the refractive index of the layers of RIR 7 are selected appropriately.

In the Laser embodiments considered above (Figs. 1-10), a further decrease in *j*ₜₕᵣ can be effected if the side facets 33 of RIR 7 are made inclined and have reflective coatings 11 applied to them. Fig. 22 shows a cross-section of these Lasers 1 for the most desirable angle of inclination β, which is positive and equal to ϕ. The reduction of *j*ₜₕᵣ is due to the fact that a significant fraction of the narrow-directed spontaneous outgoing radiation (Δϕ is 0.8°), after directly impinging on inclined side facets 33, will be reflected from them and, after returning to the GR (almost entirely, except a small fraction that will be absorbed in the RIR), will take part in increasing the stimulated radiation directed at outflow angles ϕ to optical facets 8 and 9 (see Figs. 1-10). To produce the largest effect, the angle of inclination β should be disposed in a range from (β - Δϕ/2) to (β + Δϕ/2). Another peculiarity of these embodiments (Figs. 22, 1-10, and 13) is the two-layer RIR 7, which consists of an electrically conductive first layer 31 and a second layer 32, which are made of GaAs. Ohmic contact 16 was made with first layer 31. This made it possible, by virtue of the higher transparency of layer 32, which is made of slightly doped GaAs, to reduce losses of laser radiation in RIR 7.

Figs. 23-26 present embodiments of Laser 1 in which, in contrast to the preceding ones, RIR 7 is implemented as a truncated right circular cone. In these embodiments the spontaneous narrow-directed radiation in any vertical plane that passes through the symmetry axis of RIR 7 emerges from the GR predominantly at angles ϕ, is incident on the output surfaces at a right angle, and participates, with almost the maximum possible efficiency, in the generation of stimulated radiation. Once the lasing threshold is exceeded, a spatial mode (or modes) of radiation arises (arise) with its (their) characteristic spatial and spectral characteristics. The maximum energy characteristics (low *i*ₜₕᵣ, high efficiency η, and radiation power P (relation (16)) of these embodiments of Laser 1 are due to the high efficiency of conversion of electric current into spontaneous narrow-directed radiation, and to the maximum coincidence of the spatial modes of the laser radiation and spontaneous radiation. For the embodiments of Laser 1 in Figs. 23 and 24, RIR 7 is a single-layer region, and the angle of inclination y of the generatrices of side surface 34 to inner surface 18 of conical RIR 7 is equal to (3π/4 - ϕ/2), specifically 125°, since ϕ is equal to 20°. Note that in the case of a conical RIR 7, the angle y is calculated in the direction from inner surface 18; the angle y therefore always is of the same sign, that is, it is positive. Because of the small thickness of cladding layer 5 the diameter of the circle of the GR (or of active layer 3) is practically equal to the diameter of inner surface 18 ― the bottom base of the cone. Partially reflective coatings 12, which provide negative optical feedback in the optical resonator, are applied to outer surfaces 17 about its circular periphery. Highly directional laser radiation with diffraction divergence emerges through outer surface 17 of RIR 7 at a right angle to the plane of active layer 3.

The difference between the embodiment of Laser 1 in Figs. 25 and 26 is that the side surface 34 of the cone is the reflectors of the optical resonator, and RIR 7 is a two-layer surface. The first layer 31 is made of electrically conductive GaAs, and the second layer 32 is made of lightly doped *p*-type GaP, and ohmic contact 16 is made with first layer 31. The side surface 34 with a reflection coefficient of 0.32 is made without coatings 12. The barrier regions 6 introduced into heterostructure 2 determined the shape of the GR in the form of a circle coaxial with the bases of second layer 32 of RIR 7. The diameter of the GR was selected to be smaller than the diameter of the base of the second layer 32 of RIR 7 adjacent to the GR, which made it possible to eliminate the undesirable losses of current carriers in the GR that occurred as a result of the finite thickness of layer 31 of RIR 7. The composition of the cladding layers and sublayers of heterostructure 2 was changed so that the effective refractive index of Laser 1 turned out to be 3.1475. The angle ϕ (relation (2)) in the first layer 31 changed and became 26.75°, and in the second layer 32 the angle ϕ₂ became 5°. The angle of inclination γ₂ of the generatrices of the side surface 34 of the cone in the second layer 32 of RIR 7 was equal to (π/2 - ϕ), specifically 85°. In this embodiment of the Laser (Figs. 25 and 26), the optical losses of laser radiation in RIR 7 are reduced as a result of the high transparency of GaP for a λ of 0.98 µm (here, the bandgap *E*_{RIR} exceeds *E*ₐ by approximately 1.0 eV), the optical losses of laser radiation in RIR 7 are reduced, and furthermore, the thickness of RIR 7 is reduced as a result of the decrease in the angle ϕ₂ in layer 32, and the electrical resistance of Laser 1 is reduced as a result of the increase in the doping of layer 31. For this embodiment of Laser 1, the highly directional laser radiation emerges through side surface 34 of the cone at an angle of 5° to the plane of active layer 3. Note that similar two-layer RIRs 7 also can be used in other embodiments of Laser 1 (Figs. 1-10).

The embodiments of Laser 1 (see Figs. 14-21) differ from the previous ones in that their designs include two or more (a multiplicity of) gain regions. A characteristic feature of multibeam Laser 1 (Figs. 14 and 15) is that 32 × 30 GRs that are series-parallel coupled by the operating current are disposed on the inner surface 18 of RIR 7. The length and width of each GR are 290 and 85 µm, respectively. They are arranged in the form of a rectangular grating whose spacings along and across the length *L*_{IRIR} of the RIR are 300 and 100 µm, respectively. The length *L*_{IRIR} and width *W*_{IRIR} of the inner surface 18 of RIR 7 are 9,600 and 3,000 µm, respectively, the thickness of RIR 7 is 3,214 µm, the length *L*_{OR} of the optical resonator is 10,216 µm, and the reflection coefficients of coatings 11 and 12 on facets 8 and 9 are 0.999 and 0.32, respectively. The basic parameters for the laser beams from each GR are: *j*ₜₕᵣ, αₒᵤₜ, µ, and (µ · α_{RIR}), with values of 182 A/cm², 19.95 cm⁻¹, 35.2, and 3.52 cm⁻¹, respectively, and consequently α_{RIR-thr} is 23.47 cm⁻¹; the threshold current *J*ₜₕᵣ is 43.7 mA, the operating current *J*ₒₚₑᵣ was selected to be 600 mA, and the output power of laser monomode radiation P (relation (16)) was 592.6 mW; here, η_{d} (relation (8)) is 0.8421, and η (relation (12)) is 0.7808, and the angles of divergence Θ₁ and Θ₂ are 9.0 mrad and 8 28 mrad respectively

Thirty GRs, which are in each of 32 rows of the grating that are positioned across the length of the RIR, are electrically interconnected in series, and the rows themselves are connected in parallel. The galvanic series coupling of the aforementioned GRs is implemented (see Fig. 15 and Fig. 14) by introducing an electrically conductive first layer 31 (with a carrier concentration of 10¹⁸ cm⁻³) of RIR 7, an insulating region 35 of width 15 µm, metallization layers 36 to ohmic contacts 15, connecting ohmic contacts 15 of two such adjacent GRs, between which is an insulating region 35 that borders (in contrast to barrier region 6) on the insulating region with layer 32 of RIR 7 (see Fig. 15). The aforementioned metallization layers 36, which also provide a parallel current connection of the aforementioned 32 rows of GRs, are implemented as 16 lines 180 µm wide and 9,600 µm long. In the working device, to each GR there will correspond a radiation near field and an output laser beam on the reflector with a partially reflective coating 12. If the dimensions and length of the optical resonator and of the GR itself are chosen properly, they will not overlap (see Fig. 14). The total operating current through Laser 1 is 3.2 A for an operating voltage of 48 V (1.6 V for each GR), and the total output power of all laser beams is 568.9 W.

A characteristic feature of the embodiments of Lasers 1 (see Figs. 16-19) is that a single RIR 7 with common facets 8 and 9 is formed for a linear sequence (line) of GRs. The line of intersection of the plane of the active layer with the extension of the planes of facets 8 and 9 subtends a right angle with the gain axes of the gain regions in the aforementioned line. The device may contain a fairly large number of such lines, which are monolithically joined by heterostructure 2 with barrier regions 6, which is common to all the lines. A separate laser beam will correspond to each GR in each such line of GRs. The direction of radiation output from such multibeam Lasers 1, with a multiplicity of separate GRs, may be either perpendicular to the plane of active layer 3 (see Figs. 16 and 17) or at an angle ϕ (see Fig. 18). In contrast to Lasers 1 (Figs. 14 and 15), the thickness of RIR 7 in Lasers 1 (Figs. 16-19) may be reduced significantly, and the density of the laser beams per square centimeter may be significantly increased.

In the embodiment of Laser 1 in Figs. 16 and 19, 32 linear sequences of GRs (lines), each of which contains 30 GRs that have the same dimensions and parameters as the embodiment of Laser 1 in Figs. 8 and 11, are made on the inner surfaces 18 of the 32 RIRs 7. With the exception of its width of 750 µm, RIR 7 has the same dimensions and characteristics as the embodiment of Laser 1 in Figs. 8 and 11. On each of four sides, the GRs are current separated by barrier regions 6, and an independent ohmic contact 15 with contact layer 14 is made by known methods. The spacing of the GRs in the line is 25 µm, and the spacing between lines is 135 µm. For independent supply of operating current to each GR, 30 longitudinal strips of metallization layers 36 are made to ohmic contacts 15, and 32 transverse strips of metallization layers 37, which are directed transverse to the optical gain axes of the GRs, are formed to the ohmic contacts 16 of each of the 32 RIRs. When an electrical signal is supplied to an arbitrary combination of two mutually perpendicular metallization strips 36 and 37, the laser beam is generated with the involvement of that GR which is disposed between intersecting strips 36 and 37 of the selected metallization strips. Each laser beam (of which there are 960 in all) has the same parameters as in the embodiment of Laser 1 in Figs. 9 and 11.

The embodiments of Laser 1 (see Figs. 20 and 21) include several GRs that are connected in series, one after another, into a common optical resonator. This is accomplished by virtue of rereflections from the outer optical surface 17 of RIR 7 (Fig. 20) and by virtue of reflections, with the corresponding gain in laser radiation, from gain regions disposed on both surfaces of RIR 7 (Fig. 21). These embodiments provide an increased effective length of the optical resonator for smaller thicknesses of RIR 7, including [situations with] large outflow angles ϕ. Furthermore, in them conditions more conducive to heat removal are provided as a result of the distributed nature of the heat sources in the gain regions.

Note also that for the embodiments considered for Laser 1 (Figs. 14-21), certain electrical connections of the longitudinal and transverse strips of metallization layers 36 and 37 can be used to obtain series, parallel, or series-parallel galvanic coupling of the gain regions in the embodiments of Laser 1 (see Figs. 14-21). This makes it possible to perform more effective matching of high-power multibeam lasers to power sources.

Thus, in the proposed Lasers the output power of the laser radiation is increased manifold, the threshold current densities are reduced significantly and the angles of divergence in two mutually perpendicular directions are reduced, the effective lengths of optical resonators are increased, near-maximum values of the efficiencies (including the differential efficiency) are attained, and the dependence of the generated wavelength of the laser radiation on the pumping-current amplitude is reduced significantly. High-efficiency lasers with output of laser beams, including output in the direction perpendicular to the plane of the active layer, and multibeam lasers, including those turned on independently, also are proposed.

### Commercial Applicability

Injection lasers are used in fiber-optic communications and data-transmission systems, in ultra-high-speed optical computing and switching systems, in the design of medical equipment, laser process equipment, and frequency-doubled lasers, and for the pumping of solid-state and fiber lasers.

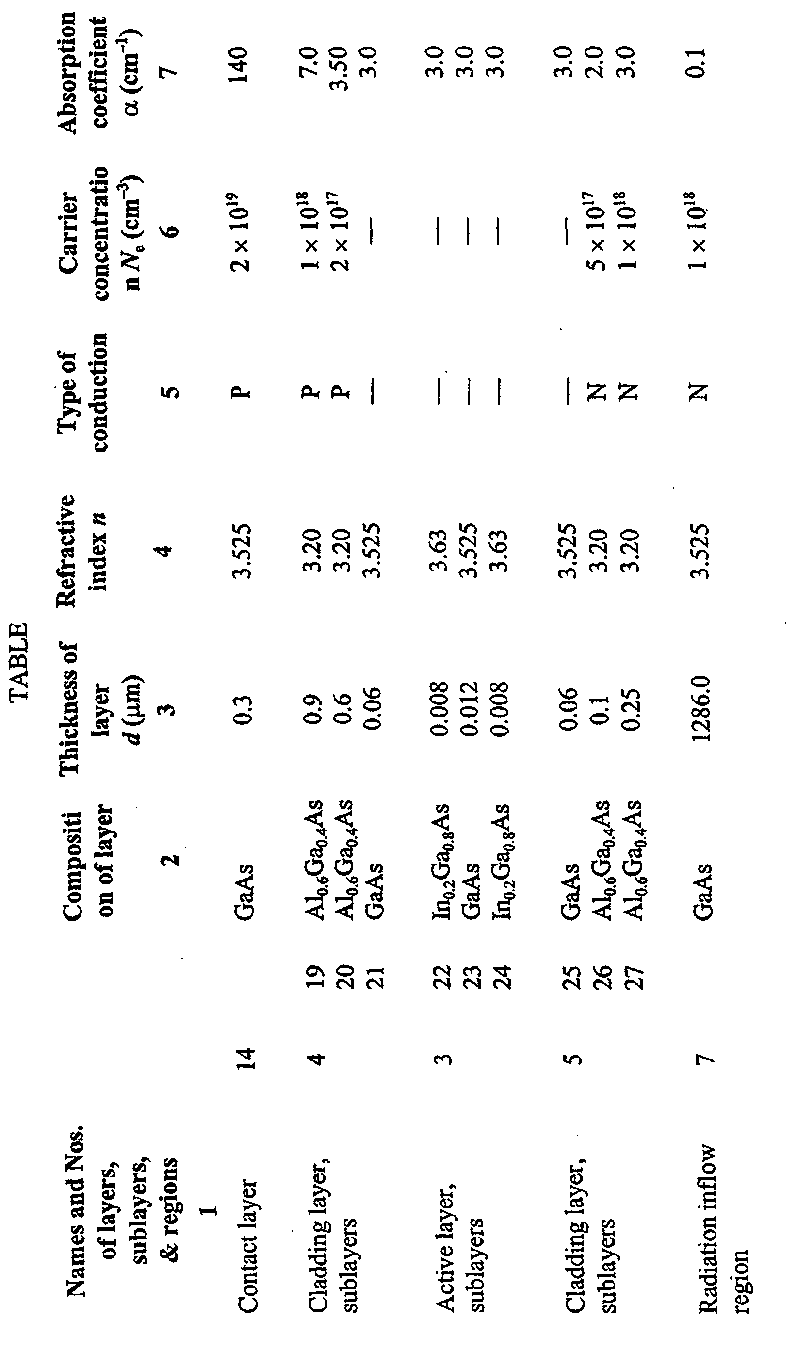

## Claims

1. An injection laser, which includes a laser heterostructure that comprises an active layer and cladding layers and in which it is possible to form a gain region, as well as reflectors, an optical resonator, ohmic contacts, and on at least one side of the active layer, a radiation inflow region whose inner surface borders on the corresponding cladding layer, the condition for radiation outflow from the active layer into the radiation inflow region is fulfilled if the refractive index *n*_{RIR} of the radiation inflow region exceeds the effective refractive index *n*_{eff} for an aggregate that consists of the laser heterostructure and the adjoining radiation inflow region, specifically, for arccos (*n*_{eff}/*n*_{RIR}) greater than zero, said injection laser being *distinctive* in that at least part of the medium of the optical resonator is made of at least part of the inflow region, and of at least part of the gain region, and at least one of the reflectors of the optical resonator is made with a reflection coefficient selected from the range greater than zero and less than one, at least one inflow region transparent to laser radiation is made, and at least one gain region formed from at least one part is characterized by an introduced gain *G*_{outflow} (cm⁻¹) of radiation outgoing from the active layer into the inflow region, the inflow region is characterized by an introduced threshold loss factor α_{RIR-thr} (cm⁻¹), the value of the gain *G*_{outflow} (cm⁻¹) is selected to be greater than the value of the factor α_{RIR-thr} (cm⁻¹), and the condition for outflow of radiation from the active layer into the radiation inflow region is further defined by the relations:$\text{arccos (} {\text{n}}_{\text{eff}} \text{/} {\text{n}}_{\text{RIR}} \text{) ≤ arccos (} {\text{n}}_{\text{eff-min}} \text{/} {\text{n}}_{\text{RIR}} \text{),}$ where *n*_{eff-min} is greater than *n*ₘᵢₙ, and *n*_{eff-min} is the minimum value of *n*_{eff} out of all possible *n*_{eff} for the multiplicity of laser heterostructures with radiation inflow regions that are of practical interest, and *n*ₘᵢₙ is the smallest of the refractive indices in the cladding layers of the heterostructure.

2. An injection laser as in Claim 1, which is distinctive in that the active layer is formed of at least one sublayer.

3. An injection laser as in any of the claims, which is distinctive in that the cladding layers, which are respectively disposed on the first and opposite second surfaces of the active layer, are formed of cladding sublayers I_{*i*} and II_{*j*}, respectively, where *i* = 1, 2, ..., *k* and *j* = 1, 2, ..., *m* are defined as integers that designate the sequential numbers of the cladding sublayers, counted from the active layer, with refractive indices *n*_{I}_{*i*} and *n*_{II}_{*j*} and bandgaps E_{I}_{*i*} and E_{II}_{*j*}, respectively, and at least one cladding sublayer is made in each cladding layer.

4. An injection laser as in any of the claims, which is distinctive in that at least one of the angles of inclination ψ of the optical facets of the radiation inflow region relative to the plane perpendicular to the longitudinal gain axis, called the normal plane, is greater than zero in absolute value; here, the angle of inclination ψ is arbitrarily said to be positive if the optical facet subtends an acute angle with the inner surface, and to be negative if the optical facet subtends an obtuse angle with the inner surface.

5. An injection laser as in any of the claims, which is distinctive in that barrier regions are introduced into the laser heterostructure.

6. An injection laser as in any of the claims, which is distinctive in that the gain region is selected to be of a strip type.

7. An injection laser as in any of the claims, which is distinctive in that the length *L*_{IRIR} of the inner surface of the radiation inflow region, as determined along the longitudinal gain axis of the gain region, and the width *W*_{RIR} of the radiation inflow region are respectively no smaller than the length *L*_{GR} and width *W*_{GR} of the gain region.

8. An injection laser as in any of the claims, which is distinctive in that the thickness of the radiation inflow region is selected from the range from 2 µm to 50,000 µm.

9. An injection laser as in any of the claims, which is distinctive in that the radiation outflow region is made of an optically homogeneous material.

10. An injection laser as in Claim 9, which is distinctive in that the radiation inflow region is made of a semiconductor having a bandgap *E*_{RIR} (eV) that exceeds the bandgap *E*ₐ (eV) of the active layer by more than 0.09 eV.

11. An injection laser as in any of the claims, which is distinctive in that the radiation inflow region is made of an introduced substrate.

12. An injection laser as in any of the claims, which is distinctive in that the radiation inflow region is made electrically conductive.

13. An injection laser as in Claim 12, which is distinctive in that an ohmic contact is formed with the surface of the radiation inflow region.

14. An injection laser as in any of the claims, which is distinctive in that a part of the volume of the radiation inflow region that borders on the laser heterostructure, of thickness no greater than *W*_{GR} (µm), is made electrically conductive, and the remaining volume is made of a material with an optical loss factor α_{RIR} of no more than 0.1 cm⁻¹.

15. An injection laser as in any of the claims, which is distinctive in that parts of the radiation inflow region that are layers parallel to its inner surface are made of materials that have different refractive indices.

16. An injection laser as in Claim 14 or 15, which is distinctive in that an ohmic contact is made with the electrically conductive part of the radiation inflow region.

17. An injection laser as in any of the claims, which is distinctive in that the radiation inflow region is made to have an optical loss factor α_{RIR} of no more than 0.1 cm⁻¹.

18. An injection laser as in any of claims 1-11, 15, and 17, which is distinctive in that an ohmic contact from the direction of the radiation inflow region is made with one of the electrically conductive cladding sublayers disposed between the active layer and the radiation inflow region.

19. An injection laser as in Claim 18, which is distinctive in that an ohmic contact is made with the electrically conductive sublayer that has the smallest bandgap value.

20. An injection laser as in any of the claims, which is distinctive in that at least one of the cladding sublayers is made with a refractive index of at least *n*_{RIR.}

21. An injection laser as in any of the claims, which is distinctive in that on at least one side of the gain region its end surface is made with the same angle of inclination and the same reflection coefficient as the adjacent optical facet of the radiation inflow region.

22. An injection laser as in any of claims 1-21, which is distinctive in that at least one optical facet implemented as a reflector of the optical resonator is formed with a positive angle of inclination ψ equal to the outflow angle ϕ, which is equal to arccos (*n*_{eff}/*n*_{RIR}).

23. A device as in any of claims 1-22, which is distinctive in that at least one optical facet is formed with a negative angle of inclination ψ equal to (π/4) - (ϕ/2), and at least part of the outer surface of the radiation inflow region, at least at the point of the projection of the optical facet onto it, is implemented as a reflector of the optical resonator.

24. An injection laser as in any of claims 1-23, which is distinctive in that at least one optical facet is formed with a positive angle of inclination ψ equal to (π/4) + (ϕ/2), and at least part of the surface of the injection laser that is opposite the inflow region is implemented, at least at the point of the projection of the optical facet onto it, as a reflector of the optical resonator.

25. An injection laser as in any of claims 22-24, which is distinctive in that another optical facet is formed with an angle of inclination ψ of zero.

26. An injection laser as in Claim 25, which is distinctive in that an introduced reflective coating is made on the aforementioned optical facet.

27. An injection laser as in any of claims 22-26, which is distinctive in that at least one of the reflectors of the optical resonator is implemented as an external reflector.

28. An injection laser as in any of Claim 27, which is distinctive in that both optical facets of the radiation inflow region are formed with an angle of inclination ψ of zero.

29. An injection laser as in Claim 27 or 28, which is distinctive in that at least one of the reflectors of the optical resonator is implemented as a plane mirror.

30. An injection laser as in any of claims 22-28, which is distinctive in that at least one of the reflectors of the optical resonator is implemented as a cylindrical mirror.

31. An injection laser as in any of claims 22-28, which is distinctive in that at least one of the reflectors of the optical resonator is implemented as a spherical mirror.

32. An injection laser as in any of claims 22-28, which is distinctive in that at least one of the reflectors of the optical resonator is implemented as a diffraction grating.

33. An injection laser as in any of claims 22-32, which is distinctive in that at least one of the introduced side optical facets of the radiation inflow region is made sloped with an angle of inclination β to the vertical plane that is perpendicular to the active layer and that passes through the longitudinal gain axis; the angle of inclination β is arbitrarily said to be positive if the side optical facet subtends an acute angle with the inner surface, or to be negative if the side optical facet subtends an obtuse angle with the inner surface.

34. An injection laser as in Claim 33, which is distinctive in that at least one side optical facet with a reflective coating made on it is formed with a positive angle of inclination β equal to the outflow angle ϕ.

35. An injection laser as in Claim 33 or 34, which is distinctive in that at least one side optical facet is formed with a negative angle of inclination β equal to the angle (π/4 - ϕ/2), and on at least part of the outer surface of the radiation inflow region a reflective coating is made on at least part of the projection of the side optical facet onto it.

36. An injection laser as in any of claims 33-35, which is distinctive in that at least one side optical facet is formed with a positive angle of inclination β equal to (π/4 + ϕ/2), and a reflective coating is made on at least part of the surface of the injection laser that is opposite the radiation inflow region, in at least part of the projection of the side optical facet onto it.

37. An injection laser as in any of claims 1-21, which is distinctive in that the radiation inflow region is formed as a truncated right circular cone, one of whose bases is the inner surface, and the reflector of the optical resonator is disposed on at least part of the output surface.

38. An injection laser as in Claim 37, which is distinctive in that a reflective coating is made on at least part of the output surface.

39. An injection laser as in Claim 37 or 38, which is distinctive in that the angles of inclination y of the generatrices of the side surface of the cone with its inner surface are selected to be (π/2 - ϕ).

40. An injection laser as in Claim 37 or 38, which is distinctive in that the angles of inclination y of the generatrices of the side surface of the cone with its inner surface are selected to be (3π/4 - ϕ/2).

41. An injection laser as in Claim 37 or 38, which is distinctive in that the angles of inclination γ of the generatrices of the side surface of the cone with its inner surface are selected to be (π/4 - ϕ/2).

42. An injection laser as in any of claims 1-41, which is distinctive in that at least two gain regions with identical outflow angles ϕ on the inner surface of at least one radiation inflow region are formed.

43. An injection laser as in Claim 42, which is distinctive in that an independent ohmic contact is made with each gain region from the direction opposite the location of the radiation inflow region.

44. An injection laser as in Claim 21, or 42, or 43, which is distinctive in that the gain regions are formed of at least two sequences of gain regions, in which are disposed at least two gain regions; the longitudinal gain axes of each gain region in each sequence are parallel to each other, and are disposed at a right angle to the line of intersection of the active layer with an extension of the plane of the optical facet of the common radiation inflow region for each sequence of gain regions.

45. An injection laser as in Claim 44, which is distinctive in that ohmic contacts and introduced metallization layers to them are made in the form of strips of at least metallization layers for each aforementioned sequence of gain regions from the direction of the radiation inflow region, on at least part of the outer surfaces of the aforementioned common inflow regions

46. An injection laser as in Claim 44, which is distinctive in that on its surface the metallization layers to the independent ohmic contacts are made, on the side opposite the disposition of the radiation inflow region, in the form of strips that are insulated from each other and that are positioned parallel to the gain axes of the gain regions.

47. An injection laser as in Claim 42 or 43, which is distinctive in that the gain regions are formed along at least one line parallel to the longitudinal gain axes of the gain regions.

48. An injection laser as in Claim 47, which is distinctive in that the gain regions are formed with a spacing between the starts of the gain regions that is equal to 2*d*_{RIR}/tan ϕ; the outer surface is made to be optically reflective, at least at points of projections of the gain regions onto it at the outflow angle ϕ.

49. An injection laser as in claims 1-43 or 47, which is distinctive in that for at least one gain region having identical outflow angles ϕ is formed on opposite surfaces of the radiation inflow region along two lines that are parallel to each other and to the longitudinal gain axes of the gain regions, the shortest distance between the starts of gain regions on opposite sides of the radiation inflow region being *d*_{RIR}/sin ϕ.

50. An injection laser as in any of claims 14-19, or as in any of claims 42-44, or as in any of claims 47-49, which is distinctive in that at least two adjacent gain regions are galvanically isolated all the way to the nonconductive part of the volume of the inflow region, and the ohmic contacts of the aforementioned gain regions are galvanically coupled by a metallization layer.

## Amended claims

### Amended claims under Art. 19.1 PCT

**1.** An injection laser, which includes a laser heterostructure that comprises an active layer and cladding layers and in which it is possible to form a gain region, as well as reflectors, an optical resonator, ohmic contacts, and on at least one side of the active layer, a radiation inflow region whose inner surface borders on the corresponding cladding layer, the condition for radiation outflow from the active layer into the radiation inflow region is fulfilled if the refractive index *n*_{RIR} of the radiation inflow region exceeds the effective refractive index *n*_{eff} for an aggregate that consists of the laser heterostructure and the adjoining radiation inflow region, specifically, for arccos (*n*_{eff}/*n*_{RIR}) greater than zero, said injection laser being *distinctive* in that at least part of the medium of the optical resonator is made of at least part of the radiation inflow region, and of at least part of the gain region, and at least one of the reflectors of the optical resonator is made with a reflection coefficient selected from the range greater than zero and less than one, and while the injection laser is in operation lasing is effected in the aforementioned optical resonator, at least one inflow region transparent to laser radiation is made, at least one gain region is formed from at least one part, and the condition for outflow of radiation from the active layer into the radiation inflow region is further defined by the relations:$\text{arccos (} {\text{n}}_{\text{eff}} \text{/} {\text{n}}_{\text{RIR}} \text{) ≤ arccos (} {\text{n}}_{\text{eff-min}} \text{/} {\text{n}}_{\text{RIR}} \text{),}$ where *n*_{eff-min} is greater than *n*ₘᵢₙ, and *n*_{eff-min} is the minimum value of *n*_{eff} out of all possible *n*_{eff} for the multiplicity of laser heterostructures with radiation inflow regions that are of practical interest, and *n*ₘᵢₙ is the smallest of the refractive indices in the cladding layers of the heterostructure.

**2.** An injection laser as in Claim 1, which is distinctive in that, in order to effect lasing, in the operating injection laser the value of the gain *G*_{outflow} (cm⁻¹) characterizing the gain region is selected to exceed the threshold loss factor α_{RIR-thr} (cm⁻¹) that characterizes the radiation inflow region.

**3.** An injection laser as in any of the claims, which is distinctive in that the active layer is formed of at least one sublayer.

**4.** An injection laser as in any of the claims, which is distinctive in that the cladding layers, which are respectively disposed on the first and opposite second surfaces of the active layer, are formed of cladding sublayers I_{*i*} and II_{*j*}, respectively, where *i* = 1, 2, ..., *k* and *j* = 1, 2, ..., *m* are defined as integers that designate the sequential numbers of the cladding sublayers, counted from the active layer, with refractive indices *n*_{I}_{*i*} and *n*_{II}_{*j*} and bandgaps *E*_{I}_{*i*} and *E*_{II}_{*j*}, respectively, and at least one cladding sublayer is made in each cladding layer.

**5.** An injection laser as in any of the claims, which is distinctive in that at least one of the angles of inclination ψ of the optical facets of the radiation inflow region relative to the plane perpendicular to the longitudinal gain axis, called the normal plane, is greater than zero in absolute value; here, the angle of inclination ψ is arbitrarily said to be positive if the optical facet subtends an acute angle with the inner surface, and to be negative if the optical facet subtends an obtuse angle with the inner surface.

**6.** An injection laser as in any of the claims, which is distinctive in that barrier regions are introduced into the laser heterostructure.

**7.** An injection laser as in any of the claims, which is distinctive in that the gain region is selected to be of a strip type.

**8.** An injection laser as in any of the claims, which is distinctive in that the length *L*_{IRIR} of the inner surface of the radiation inflow region, as determined along the longitudinal gain axis of the gain region, and the width *W*_{RIR} of the radiation inflow region are respectively no smaller than the length *L*_{GR} and width *W*_{GR} of the gain region.

**9.** An injection laser as in any of the claims, which is distinctive in that the thickness of the radiation inflow region is selected from the range from 2 µm to 50,000 µm.

**10.** An injection laser as in any of the claims, which is distinctive in that the radiation inflow region is made of an optically homogeneous material.

**11.** An injection laser as in Claim 10, which is distinctive in that the radiation inflow region is made of a semiconductor having a bandgap *E*_{RIR} (eV) that exceeds the bandgap *E*ₐ (eV) of the active layer by more than 0.09 eV.

**12.** An injection laser as in any of the claims, which is distinctive in that the radiation inflow region is made of an introduced substrate.

**13.** An injection laser as in any of the claims, which is distinctive in that the radiation inflow region is made electrically conductive.

**14.** An injection laser as in Claim 13, which is distinctive in that an ohmic contact is formed with the surface of the radiation inflow region.

**15.** An injection laser as in any of the claims, which is distinctive in that a part of the volume of the radiation inflow region that borders on the laser heterostructure, of thickness no greater than *W*_{GR} (µm), is made electrically conductive, and the remaining volume is made of a material with an optical loss factor α_{RIR} of no more than 0.1 cm⁻¹.

**16.** An injection laser as in any of the claims, which is distinctive in that parts of the radiation inflow region that are layers parallel to its inner surface are made of materials that have different refractive indices.

**17.** An injection laser as in Claim 15 or 16, which is distinctive in that an ohmic contact is made with the electrically conductive part of the radiation inflow region.

**18.** An injection laser as in any of the claims, which is distinctive in that the radiation inflow region is made to have an optical loss factor α_{RIR} of no more than 0.1 cm⁻¹.

**19.** An injection laser as in any of claims 1-12, 16, and 18, which is distinctive in that an ohmic contact from the direction of the radiation inflow region is made with one of the electrically conductive cladding sublayers disposed between the active layer and the radiation inflow region.

**20.** An injection laser as in Claim 19, which is distinctive in that an ohmic contact is made with the electrically conductive sublayer that has the smallest bandgap value.

**21.** An injection laser as in any of the claims, which is distinctive in that at least one of the cladding sublayers is made with a refractive index of at least *n*_{RIR.}

**22.** An injection laser as in any of the claims, which is distinctive in that on at least one side of the gain region its end surface is made with the same angle of inclination and the same reflection coefficient as the adjacent optical facet of the radiation inflow region.

**23.** An injection laser as in any of the previous claims, which is distinctive in that at least one optical facet implemented as a reflector of the optical resonator is formed with a positive angle of inclination ψ equal to the outflow angle ϕ, which is equal to arccos (*n*_{eff}/*n*_{RIR}).

**24.** An injection laser as in any of the previous claims, which is distinctive in that at least one optical facet is formed with a negative angle of inclination ψ equal to (π/4) - (ϕ/2), and at least part of the outer surface of the radiation inflow region, at least at the point of the projection of the optical facet onto it, is implemented as a reflector of the optical resonator.

**25.** An injection laser as in any of the previous claims, which is distinctive in that at least one optical facet is formed with a positive angle of inclination ψ equal to (π/4) + (ϕ/2), and at least part of the surface of the injection laser that is opposite the inflow region is implemented, at least at the point of the projection of the optical facet onto it, as a reflector of the optical resonator.

**26.** An injection laser as in any of claims 23-25, which is distinctive in that another optical facet is formed with an angle of inclination ψ of zero.

**27.** An injection laser as in Claim 26, which is distinctive in that an introduced reflective coating is made on the aforementioned optical facet.

**28.** An injection laser as in any of claims 23-27, which is distinctive in that at least one of the reflectors of the optical resonator is implemented as an external reflector.

**29.** An injection laser as in any of Claim 28, which is distinctive in that both optical facets of the radiation inflow region are formed with an angle of inclination ψ of zero.

**30.** An injection laser as in Claim 28 or 29, which is distinctive in that at least one of the reflectors of the optical resonator is implemented as a plane mirror.

**31.** An injection laser as in any of claims 23-29, which is distinctive in that at least one of the reflectors of the optical resonator is implemented as a cylindrical mirror.

**32.** An injection laser as in any of claims 23-29, which is distinctive in that at least one of the reflectors of the optical resonator is implemented as a spherical mirror.

**33.** An injection laser as in any of claims 23-29, which is distinctive in that at least one of the reflectors of the optical resonator is implemented as a diffraction grating.

**34.** An injection laser as in any of claims 23-33, which is distinctive in that at least one of the introduced side optical facets of the radiation inflow region is made sloped with an angle of inclination β to the vertical plane that is perpendicular to the active layer and that passes through the longitudinal gain axis; the angle of inclination β is arbitrarily said to be positive if the side optical facet subtends an acute angle with the inner surface, or to be negative if the side optical facet subtends an obtuse angle with the inner surface.

**35.** An injection laser as in Claim 34, which is distinctive in that at least one side optical facet with a reflective coating made on it is formed with a positive angle of inclination β equal to the outflow angle ϕ.

**36.** An injection laser as in Claim 34 or 35, which is distinctive in that at least one side optical facet is formed with a negative angle of inclination β equal to the angle (π/4 - ϕ/2), and on at least part of the outer surface of the radiation inflow region a reflective coating is made on at least part of the projection of the side optical facet onto it.

**37.** An injection laser as in any of claims 34-36, which is distinctive in that at least one side optical facet is formed with a positive angle of inclination β equal to (π/4 + ϕ/2), and a reflective coating is made on at least part of the surface of the injection laser that is opposite the radiation inflow region, in at least part of the projection of the side optical facet onto it.

**38.** An injection laser as in any of claims 1-22, which is distinctive in that the radiation inflow region is formed as a truncated right circular cone, one of whose bases is the inner surface, and the reflector of the optical resonator is disposed on at least part of the output surface.

**39.** An injection laser as in Claim 38, which is distinctive in that a reflective coating is made on at least part of the output surface.

**40.** An injection laser as in Claim 38 or 39, which is distinctive in that the angles of inclination y of the generatrices of the side surface of the cone with its inner surface are selected to be (π/2 - ϕ).

**41.** An injection laser as in Claim 38 or 39, which is distinctive in that the angles of inclination γ of the generatrices of the side surface of the cone with its inner surface are selected to be (3π/4 - ϕ/2).

**42.** An injection laser as in Claim 38 or 39, which is distinctive in that the angles of inclination γ of the generatrices of the side surface of the cone with its inner surface are selected to be (π/4 - ϕ/2).

**43.** An injection laser as in any of the previous claims, which is distinctive in that at least two gain regions with identical outflow angles ϕ on the inner surface of at least one radiation inflow region are formed.

**44.** An injection laser as in Claim 43, which is distinctive in that an independent ohmic contact is made with each gain region from the direction opposite the location of the radiation inflow region.

**45.** An injection laser as in Claim 22, or 43, or 44, which is distinctive in that at least two sequences of gain regions are formed, in each of which are disposed at least two gain regions; the longitudinal gain axes of each gain region in each sequence are parallel to each other, and are disposed at a right angle to the line of intersection of the active layer with an extension of the plane of the optical facet of the common radiation inflow region for each sequence of the gain region.

**46.** An injection laser as in Claim 45, which is distinctive in that ohmic contacts and introduced metallization layers to them are made in the form of strips of at least metallization layers for each aforementioned sequence of gain regions from the direction of the radiation inflow region, on at least part of the outer surfaces of the aforementioned common inflow regions

**47.** An injection laser as in Claim 45, which is distinctive in that on its surface the metallization layers to the independent ohmic contacts are made, on the side opposite the disposition of the radiation inflow region, in the form of strips that are insulated from each other and that are positioned parallel to the gain axes of the gain regions.

**48.** An injection laser as in Claim 43 or 44, which is distinctive in that the gain regions are formed along at least one line parallel to the longitudinal gain axes of the gain regions.

**49.** An injection laser as in Claim 48, which is distinctive in that the gain regions are formed with a spacing between the starts of the gain regions that is equal to 2*d*_{RIR}/tan ϕ; the outer surface is made to be optically reflective, at least at points of projections of the gain regions onto it at the outflow angle ϕ.

**50.** An injection laser as in claims 1-44, or 48, which is distinctive in that for at least one gain region having identical outflow angles ϕ is formed on opposite surfaces of the radiation inflow region along two lines that are parallel to each other and to the longitudinal gain axes of the gain regions, the shortest distance between the starts of gain regions on opposite sides of the inflow region being *d*_{RIR}/sin ϕ.

**51.** An injection laser as in any of claims 15-20, or as in any of claims 43-45, or as in any of claims 48-50, which is distinctive in that at least two adjacent gain regions are galvanically isolated all the way to the nonconductive part of the volume of the inflow region, and the ohmic contacts of the aforementioned gain regions are galvanically coupled by a metallization layer.
**EXPLANATION ACCORDING TO ARTICLE 19(1)**
We believe that it would be advisable to revise Claim 1 of the previously proposed claims, specifically, after the words "... and less than one" add the words "and when the injection laser is in operation lasing is effected in the aforementioned optical resonator," and delete from Claim 1 the passage reading as follows: "... characterized by a gain *G*_{outflow} (cm⁻¹) of outflowing radiation from the active layer into the inflow region, the latter being characterized by an introduced threshold loss factor α_{RIR-thr} (cm⁻¹), and the value of the gain *G*_{outflow} (cm⁻¹) is selected to be greater than the factor α_{RIR-thr} (cm ⁻¹), ...," and insert them into a dependent, newly introduced Claim 2. In connection with this, in the new version of the claims, the numbers of the references have been changed in dependent claims 10, 13, 16, 18, 19, 25-41, and 43-50 of the original claims, which have been replaced by claims 11, 14, 17, 19, 20, 26-42, and 44-51 of the new version, and the numbers of claims 2-50 have been replaced by 3-51, respectively. Furthermore, to simplify the notation in some of the dependent claims (specifically, in claims 23-25 and 43), the words "... from the previous claims ..." have been introduced to replace the reference numbers to previous claims.
Typographical errors and obvious mistakes that disrupt the unity of the terminology have been found in the text of the claims. On the basis of Rule 91.1 of the PCT Instructions, we ask that the following changes be accepted. In claims 1 and 50 of the original version, the word "radiation" was omitted after the words "inflow region," which has been corrected, in claims 1 and 51 of the new version, with the expression "radiation inflow region"; in claim 9 of the original version, "radiation outflow region" was mistakenly written, instead of which Claim 10 in the new version now reads "radiation inflow region"; in Claim 23 of the original version, "Device" was written, which in Claim 24 of the new version is replaced by "Injection laser..."; in Claim 44 of the original version the words "gain regions" were mistakenly written, which we have deleted from Claim 45 of the new version.
The changes made do not go beyond the scope of the disclosure of the invention in the original application materials and do not require additional disclosure of the invention once the text of the application description is corrected. No changes are needed in the drawings in the original application materials.
